(19) **Europäisches Patentamt European Patent Office Office européen des brevets**

(11) **EP 4 579 263 A2**

(12) **EUROPEAN PATENT APPLICATION**

(43) Date of publication:
**02.07.2025 Bulletin 2025/27**

(21) Application number: **24216033.1**

(22) Date of filing: **28.11.2024**

(51) International Patent Classification (IPC):
**G01R 33/00** (2006.01)     **G01R 15/00** (2006.01)
**G01R 33/025** (2006.01)

(52) Cooperative Patent Classification (CPC):
**G01R 33/025; G01R 15/00; G01R 33/0017;
G01R 33/0094; G01R 33/26**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.11.2023   US 202363604773 P
26.11.2024   US 202418961364**

(71) Applicant: **SB Technology, Inc.
Wilmington, DE 19808 (US)**

(72) Inventors:
• **Bogdanovic, Stefan
  Wilmington, 19808 (US)**

• **Joe, Graham Douglas
  Wilmington, 19808 (US)**
• **Liddy, Madelaine Susan Zoritza
  Wilmington, 19808 (US)**
• **Nguyen, Christian Thieu
  Wilmington, 19808 (US)**
• **Ruf, Maximilian Thomas
  Wilmington, 19808 (US)**
• **Rugar, Alison Emiko
  Wilmington, 19808 (US)**

(74) Representative: **Ostertag & Partner Patentanwälte mbB
Azenbergstraße 35
70174 Stuttgart (DE)**

(54) **SYSTEMS AND METHODS FOR VECTOR MAGNETOMETRY**

(57)     A method for extracting information about one or more magnetic sources includes obtaining a first plurality of signals corresponding to magnetic sensor data generated by one or more magnetometers in an unshielded environment at a first time; receiving second information of a direction and a magnitude of a first known magnetic field applied to the one or more magnetometer, the first plurality of signals is acquired while the first known magnetic field is applied and wherein the first known magnetic field encodes directional information of the one or more magnetic sources into the first plurality of signals; extracting the information comprising three-dimensional spatial information of the one or more magnetic sources, respective orientations and strengths of the one or more magnetic sources based on the first information, the second information, and the plurality of signals corresponding to the magnetic sensor data.

FIG. 4C

EP 4 579 263 A2

## Description

RELATED APPLICATION

This application claims priority to U.S. Provisional Application No. 63/604,773, filed on November 30, 2023, entitled "Systems and Methods for Vector Magnetometry", and to U.S. Application No. 18/961,364, filed on November 26, 2024, entitled "Systems and Methods for Vector Magnetometry, "which are incorporated herein by reference in their entirety.

TECHNICAL FIELD

The disclosed embodiments relate generally to systems and methods for detecting signals via magnetic field sensing.

BACKGROUND

Magnetic sensing is a technique for measuring magnetic fields produced by electric currents or current dipoles.

SUMMARY

One of the major challenges in detecting magnetic signals using unshielded magnetometers is the small/weak amplitude of the signals, masked by magnetic interference from sources external to the target. For example, in biological applications, the strength of Earth's magnetic field is approximately 50 micro Tesla ($\mu$T), which is about a million times larger in amplitude than the expected signal of the heart's magnetic field when a magnetic field sensing device (e.g., a magnetocardiogram (MCG) device) is positioned just outside the chest of a patient. Furthermore, when the magnetic field sensing device is deployed in the field (e.g., outdoor settings, a hospital, or a clinical setting). other objects in the vicinity of the magnetic field sensing device, such as computers, cellphones, TVs, or elevators in the building where the magnetic field sensing device is deployed, also generate magnetic noises and interference, thus making it even more difficult to pick out magnetic signals originating from the target. Yet, acquiring magnetic field data in a magnetically-shielded environment to isolate magnetic signals from the target as the dominant signal may be costly and impractical.

In biological applications, MCG may be less impacted by alterations in thoracic conductivity distributions than ECG. Unlike electric signals in ECGs which may be distorted during passage through body tissues, magnetic fields may be less impeded (e.g., unimpeded) by the human body, allowing MCGs to capture more intricate data from the heart. By measuring more pristine electrical conduction activities in every heartbeat, doctors can better detect abnormal patterns or uncover other indicators about potential disease states. Since MCG is less affected by body conductivity, a sensitive magnetic field sensing device could reveal subtle functional changes or hypoperfusion that might not appear in an ECG. Furthermore, MCG provides non-contact measurements, which would be valuable in applications where the use of ECG electrodes is not possible, such as in the evaluation of fetuses with life-threatening arrhythmia.

In conjunction with gradiometric magnetic field sensing, which measures the spatial gradient of a magnetic field (e.g., by using two or more magnetometers that are spaced apart to measure the difference in the magnetic field readings between the magnetometers, which is proportional to the magnetic field gradient), magnetic field sensing can be applied to create 3D magnetic maps of various terrains (e.g., subsurface exploration, or general navigation). Gradiometry is very sensitive to small changes in the magnetic field gradient and relatively immune to noise from external magnetic fields.

The magnetic field sensing systems and devices described herein may have reduced operating costs, less bulkiness in size compared to existing magnetic field sensing devices which can occupy an entire room. Unlike magnetic field sensing devices based on superconducting quantum interference device (SQUID) technology, the magnetic field sensing device systems and devices described herein do not require a magnetically-shielded environment (to achieve a near-zero magnetic field) and/or at cryogenic temperatures for operation.

Accordingly, there is a need of improved systems, methods, and devices that enable measurement of magnetic fields produced by a target. The present disclosure describes an improved magnetic field sensing system, device and method for vector magnetometry by combining hardware components and signal processing techniques to resolve the three-dimensional magnetic fields from a target. In particular, the disclosed magnetic field sensing system and measurement techniques enhances both the detection of magnetic field signals from the target as well as the application of signal processing techniques to reduce/remove signals from interference sources. Accordingly, the combination of features enables the disclosed magnetic field sensing system to be operable at room temperature and without magnetic shielding, thereby differentiating it from, and improving over, existing magnetic field sensing systems.

The disclosed magnetic field sensing device (and system) has several advantages compared to other commercially available magnetic field sensing systems. First, the disclosed device and system is operable at room temperature, in a magnetically unshielded environment, thus reducing operating costs and improving usability. Second, the disclosed magnetic field sensing system utilizes magnetometers that allow further miniaturization and/or portability of the device.

In one aspect, an apparatus (e.g., a magnetic field sensing device, a MCG device) includes one or more processors; and memory storing one or more programs, the one or more programs including instructions that, when executed by the one or more processors, cause the one or more processors to perform operations including: obtaining a first plurality of signals corresponding to magnetic sensor data generated by one or more magnetometers in an unshielded environment at a first time; receiving first information about respective locations of the one or more magnetometers, wherein the plurality of signals is acquired at the respective locations of the one or more magnetometers; receiving second information of a direction and a magnitude of a first known magnetic field applied to the one or more magnetometer. The first plurality of signals is acquired while the first known magnetic field is applied and the first known magnetic field encodes directional information of the one or more magnetic sources into the first plurality of signals. The operations further include extracting the information that includes three-dimensional spatial information of the one or more magnetic sources, respective orientations and strengths of the one or more magnetic sources based on the first information, the second information, and the plurality of signals corresponding to the magnetic sensor data; receiving a feedback signal indicative of a change in the unshielded environment sensed by the one or more magnetometers. In accordance with a determination that the feedback signal meets first criteria: the apparatus changes the first known magnetic field based on the feedback signal to provide a second known magnetic field that reduces the change in the unshielded environment sensed by the one or more magnetometers. The apparatus obtains, while the second known magnetic field is applied, a second plurality of signals corresponding to the magnetic sensor data generated by the one or more magnetometers in the unshielded environment at a second time different form the first time; and the apparatus extracts the information including the three-dimensional spatial information of the one or more magnetic sources, the respective orientations and strengths of the one or more magnetic sources based on the second plurality of signals corresponding to the magnetic sensor data at the second time.

In some embodiments, the apparatus is configured to remove noise from the plurality of signals based on the first information, the second information, and the plurality of signals corresponding to the magnetic sensor data.

In some embodiments, the one or more magnetometers each includes an electron spin defect body, wherein the electron spin defect body includes a plurality of lattice point defects.

In some embodiments, the electron spin defect body includes a nitrogen-vacancy diamond portion; and the first known magnetic field changes a characteristic of an output from the nitrogen-vacancy diamond portion.

In some embodiments, output from the nitrogen-vacancy diamond portion includes red fluorescence emitted by the nitrogen-vacancy diamond portion that is collected via a parabolic mirror positioned at an offset from the nitrogen-vacancy diamond portion.

In some embodiments, the apparatus applies the first known magnetic field to generate an output from the nitrogen-vacancy diamond portion that includes pairs of non-degenerate signals for simultaneous vector measurements (SVM).

In some embodiments, the pairs of non-degenerate signals correspond to eight distinct nitrogen-vacancy (NV) resonances that are individually addressable with microwave fields.

In some embodiments, the NV resonances are separated from one another to minimize cross-talk. In some embodiments, intermodulation products of applied microwave drive frequencies do not overlap with at least one of the NV resonances.

In some embodiments, the apparatus is configured to project a non-zero component of the first known magnetic field onto four symmetry axes of the nitrogen-vacancy diamond portion. In some embodiments, the apparatus is configured to tune an optical pump polarization to address four symmetry axes of the nitrogen-vacancy diamond portion equally while the first known magnetic field is applied.

In some embodiments, the apparatus is configured to obtain the plurality of signals corresponding to the magnetic sensor data generated by one or more magnetometers includes obtaining the plurality of signals corresponding to the magnetic sensor data generated by an array of magnetometers, the apparatus is further configured to extract the information of the magnetic source by pairing the plurality of signals corresponding to the magnetic sensor data generated by the array of magnetometers with the first information of the respective locations of the array of magnetometers.

In some embodiments, a known bias field is applied, which splits the magnetic field lines, so they do not overlap. If the applied magnetic field is known (e.g., coarsely), the applied magnetic field can be used to extract the measured magnetic field by measuring the frequency shifts of the NV lines.

In some embodiments, the first plurality of signals includes information about

$$\Delta \nu_{\bar\kappa} \, i$$

respective detected frequency shifts (e.g., $\Delta \nu_\lambda$, $\Delta \nu_\chi$, $\Delta \nu_\varphi$, ), and the apparatus is further configured to determine a transformation matrix based on the first known magnetic field, and wherein the transformation matrix is configured to transform the respective detected frequency shifts into the information about the one or more magnetic sources that includes magnetic field directions of the one or more magnetic sources (e.g., $B_x$, $B_y$ and $B_z$).'

In some embodiments, the transformation matrix includes one or more elements representative of a change in the respective detected frequency shifts along a respective magnetic field direction of the one or more magnetic sources.

In some embodiments, the magnetic field directions of the one or more magnetic sources include small excursions in magnetic field around the first known magnetic field.

In another aspect, a method for extracting information of a magnetic source, includes at a computer system having one or more processors and memory: obtaining a plurality of signals corresponding to magnetic sensor data generated by one or more magnetometers in an unshielded environment; receiving first information of respective locations of the one or more magnetometers, wherein the plurality of signals is acquired at the respective locations of the one or more magnetometers; and receiving an input to select a mode: in accordance with a determination that a first mode of operation is selected: receiving second information of a direction and a magnitude of a first known magnetic field applied to the one or more magnetometer, wherein the plurality of signals is acquired while the first known magnetic field is applied and wherein the first known magnetic field encodes directional information of the magnetic source into the plurality of signals; and extracting the information including three-dimensional spatial information of the magnetic source, an orientation of the magnetic source, and a strength of the magnetic source based on the first information, the second information, and the plurality of signals corresponding to the magnetic sensor data.

In accordance with a determination that a second mode of operation, different from the first mode of operation, is selected: suppressing off-axis noise from magnetic fields by overlapping two or more signals in the plurality of signals using a second magnetic field distinct from the first known magnetic field.

In another aspect, a computer system for determining magnetic fields, includes one or more processors; and memory; and one or more programs stored in the memory for execution by the one or more processors, the one or more programs including instructions for: obtaining a first plurality of signals corresponding to magnetic sensor data generated by one or more magnetometers in an unshielded environment at a first time; receiving first information about respective locations of the one or more magnetometers, wherein the plurality of signals is acquired at the respective locations of the one or more magnetometers; receiving second information of a direction and a magnitude of a first known magnetic field applied to the one or more magnetometer, wherein the first plurality of signals is acquired while the first known magnetic field is applied and wherein the first known magnetic field encodes directional information of one or more magnetic sources into the first plurality of signals; extracting the information including three-dimensional spatial information of the one or more magnetic sources, respective orientations and strengths of the one or more magnetic sources based on the first information, the second information, and the plurality of signals corresponding to the magnetic sensor data; receiving a feedback signal indicative of a change in the unshielded environment sensed by the one or more magnetometers.

In accordance with a determination that the feedback signal meets first criteria: changing the first known magnetic field based on the feedback signal to provide a second known magnetic field that reduces the change in the unshielded environment sensed by the one or more magnetometers; obtaining, while the second known magnetic field is applied, a second plurality of signals corresponding to the magnetic sensor data generated by the one or more magnetometers in the unshielded environment at a second time different form the first time; and extracting the information including the three-dimensional spatial information of the one or more magnetic sources, the respective orientations and strengths of the one or more magnetic sources based on the second plurality of signals corresponding to the magnetic sensor data at the second time.

In accordance with some embodiments, a computer system includes one or more processors and memory. The memory stores one or more programs configured for execution by the computer system. The one or more programs include instructions for performing any of the methods described herein.

In accordance with some embodiments, a non-transitory computer-readable storage medium stores one or more programs configured for execution by a computer system having one or more processors and memory. The one or more programs include instructions for performing any of the methods described herein.

Note that the various embodiments described above can be combined with any other embodiments described herein. The features and advantages described in the specification are not all inclusive and, in particular, many additional features and advantages will be apparent to one of ordinary skill in the art in view of the drawings, specification, and claims. Moreover, it should be noted that the language used in the specification has been principally selected for readability and instructional purposes and may not have been selected to delineate or circumscribe the inventive subject matter.

BRIEF DESCRIPTION OF THE DRAWINGS

FIG. 1 illustrates an operating environment in accordance with some embodiments.

FIG. 2 illustrates a block diagram of a device for measuring magnetic fields of a target source according to some embodiments.

FIG. 3 is a block diagram illustrating a computer system, in accordance with some implementations.

FIG. 4A to FIG. 4D illustrate various aspects of vector magnetometry in accordance with some embodiments.

FIG. 5A to FIG. 5I illustrate various aspects of a miniaturized sensor head unit, in accordance with some embodiments.

FIG. 6A and FIG. 6B microwave magnetic flux density at NV center location, for different resonator designs with loading with parabolic resonator, in accordance with some embodiments.

FIG. 7 shows example data reconstructed in three dimensions, in accordance to some embodiments.

FIG. 8 illustrates an example MW delivery chain, in accordance with some embodiments.

FIG. 9 provides a flowchart of a method for extracting information about one or more magnetic sources, in accordance with some embodiments.

FIG 10A- FIG.10Y and FIG. 10AA- FIG. 10AX illustrate magnetic flux densities for systems associated with different design parameters, in accordance with some embodiments. FIG. 10Z shows different temperature distributions, in accordance with some embodiments.

Reference will now be made to implementations, examples of which are illustrated in the accompanying drawings. In the following description, numerous specific details are set forth in order to provide a thorough understanding of the present invention. However, it will be apparent to one of ordinary skill in the art that the present invention may be practiced without requiring these specific details.

DETAILED DESCRIPTION

Some methods, devices, and systems disclosed in the present specification improve upon existing magnetic field sensing devices by providing a device and/or system that combines hardware components and signal processing techniques for resolving magnetic fields from a target.

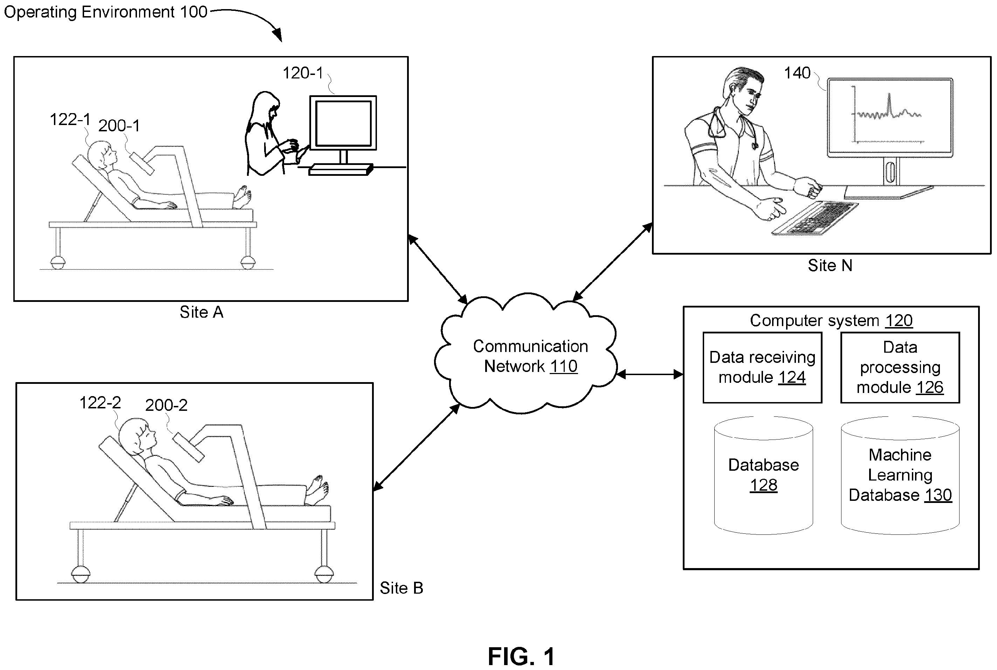

FIG. 1 illustrates an exemplary operating environment 100 in accordance with some embodiments. In some embodiments, the operating environment 100 includes one or more magnetic field sensing devices 200. In the example of FIG. 1, each of the magnetic field sensing devices 200 (e.g., 200-1 and 200-2) is located at a respective (e.g., distinct) site (e.g., Site A and Site B), corresponding to a respective (e.g., distinct) city, state, or country. In some embodiments, a site corresponds to a region bounded by GPS coordinates, hospital, a clinic, or a medical facility.

In some embodiments, a magnetic field sensing device 200 (e.g., an apparatus) is communicatively coupled through communication network(s) 110 to a computer system 120. In some embodiments, the computer system 120 and the magnetic field sensing device 200 are co-located at the same location (e.g., in the same room where the magnetic field sensing device 200 is employed). For example, FIG. 1 shows that the magnetic field sensing device 200-1 and the computer system 120-1 are located in Site A (e.g., different rooms of the same hospital, or within the same room in a hospital). In some embodiments, the magnetic field sensing device 200 and the computer system 120 are located at different locations. For example, FIG. 1 shows that the magnetic field sensing device 200-2 is located at site B whereas the computer device 120-2 is located at site N. In some embodiments, the computer system is a cloud-based system that is located on a cloud server.

As disclosed herein, the magnetic field sensing device 200 includes one or more magnetometers 201 that are configured to measure (e.g., sense, acquire, collect, obtain, etc.) magnetic field signals from a target 122 while the magnetic field sensing device 200 is operating in a magnetically unshielded environment. In some embodiments, the measured signals are transmitted to the computing system 120 for post-processing. In some embodiments, the data (e.g., actual data or post-processed data) is caused to be displayed on the computer system 120, or on a display device 140 that is communicatively connected to the computer system 120.

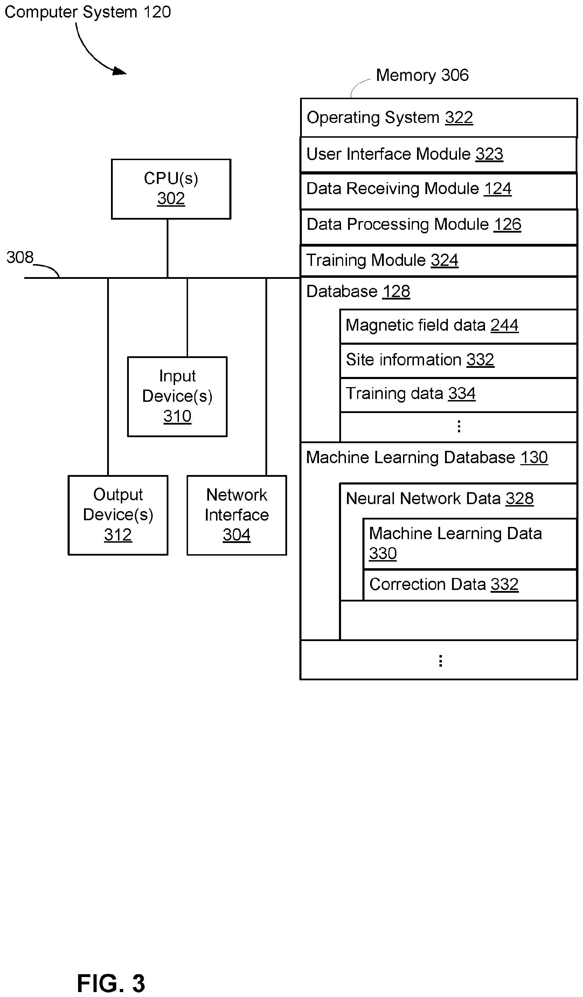

In the example of FIG. 1, the computer system 120 includes a data receiving module 124 that is configured to receive data from one or more magnetic field sensing devices 200. In some embodiments, the data corresponds to magnetic field data that is generated (e.g., measured, collected, acquired) from respective magnetometers 201 of a magnetic field sensing device 200. The computer system 120 includes a data processing module 126 that is configured to process the received data. In some embodiments, the computer system 120 includes a database 128. Details of the database 128 are described with respect to FIG. 3.

In some embodiments, the computer system 120 includes a machine learning database 130 that stores machine learning information. In some implementations, the machine learning database 130 is a distributed database. In some implementations, the machine learning database 130 includes a deep neural network database. In some implementations, the machine learning database 130 includes supervised training and/or reinforcement training databases.

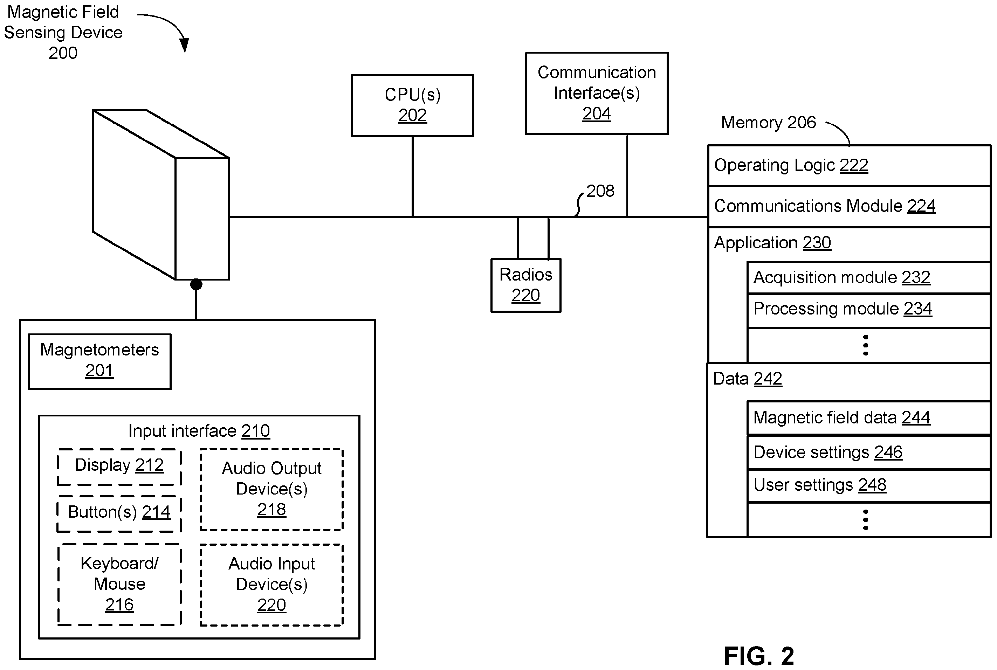

FIG. 2 shows a block diagram of a magnetic field sensing device 200 (e.g., an apparatus) according to some embodiments. The magnetic field sensing device 200 includes one or more magnetometers 201 (e.g., a magnetic field sensor).

In some embodiments, the magnetometer 201 includes an electron spin defect based magnetometer, such as a diamond nitrogen vacancy (NV) center magnetometer (e.g., a solid state sensor). A diamond NV center magnetometer is a quantum sensor that leverages the occurrence of an electronic spin defect in a solid state lattice, where the spin can be both initialized and read out optically. In some instances, the defect may arise as an atomic-level vacancy in a lattice structure, such as a vacancy occurring near a nitrogen atom that is substituted in place of a carbon atom within diamond. In some embodiments, the one or more magnetometers 201 includes at least two magnetometers that are arranged in an array. In some embodiments, the array of magnetometers is arranged in a stack of planes.

In some embodiments, the magnetic field sensing device 200 includes an input interface 210 for facilitating user input, such as a display 212, button(s) 214, a keyboard and/or mouse 216. In some embodiments, input interface 210 includes a display device 212. In some embodiments, the magnetic field sensing device 200 includes input devices such as button(s) 214, and/or a keyboard / mouse 216. Alternatively or in addition, in some embodiments, the display device 212 includes a touch-sensitive surface, in which case the display device 212 is a touch-sensitive display. In some embodiments, the touch-sensitive surface is configured to detect various swipe gestures (e.g., continuous gestures in vertical and/or horizontal directions) and/or other gestures (e.g., single/double tap). In computing devices that have a touch-sensitive display, a physical keyboard is optional (e.g., a soft keyboard may be displayed when keyboard entry is needed). The input interface 210 also includes an audio output device 218, such as speakers or an audio output connection connected to speakers, earphones, or headphones. In some embodiments, the magnetic field sensing device 200 uses a microphone 220 and voice recognition to supplement or replace the keyboard. In some embodiments, the magnetic field sensing device 200 includes an audio input device 220 (e.g., a microphone) to capture audio (e.g., speech from a user).

The magnetic field sensing device 200 also includes one or more processors (e.g., CPU(s)) 202, one or more communication interface(s) 204 (e.g., network interface(s)), memory 206, and one or more communication buses 208 for interconnecting these components (sometimes called a chipset).

In some embodiments, the magnetic field sensing device 200 includes radios 220. The radios 221 enable one or more communication networks, and allow the magnetic field sensing device 200 to communicate with other devices, such as a computer system (e.g., the computing system 120 in FIG. 1 and FIG. 3) or a server. In some embodiments, the radios 221 are capable of data communication using any of a variety of custom or standard wireless protocols (e.g., IEEE 802.15.4, Wi-Fi, Zig-Bee, 6LoWPAN, Thread, Z-Wave, Bluetooth Smart, ISA100.5A, WirelessHART, MiWi, Ultrawide Band (UWB), and/or software defined radio (SDR)) custom or standard wired protocols (e.g., Ethernet or Home-Plug), and/or any other suitable communication protocol, including communication protocols not yet developed as of the filing date of this patent application.

The memory 206 includes high-speed random access memory, such as DRAM, SRAM, DDR RAM, or other random access solid state memory devices. In some embodiments, the memory includes non-volatile memory, such as one or more magnetic disk storage devices, one or more optical disk storage devices, one or more flash memory devices, or one or more other non-volatile solid state storage devices. In some embodiments, the memory 206 includes one or more storage devices remotely located from one or more processor(s) 202. The memory 206, or alternatively the non-volatile memory within the memory 206, includes a non-transitory computer-readable storage medium. In some embodiments, the memory 206, or the non-transitory computer-readable storage medium of the memory 206, stores the following programs, modules, and data structures, or a subset or superset thereof:

- operating logic 222, including procedures for handling various basic system services and for performing hardware dependent tasks;

- a communication module 224 (e.g., a radio communication module), which connects to and communicates with other network devices (e.g., a local network, such as a router that provides Internet connectivity, networked storage devices, network routing devices, server systems, computer system 120, and/or other connected devices) coupled to one or more communication networks via the communication interface(s) 204 (e.g., wired or wireless);

- an application 230, which acquires magnetic field data (e.g., via the magnetometers 201) and/or processes the acquired data. In some embodiments, the application 230 controls one or more components of the magnetic field sensing device 200 and/or other connected devices (e.g., in accordance with the acquired data). In some embodiments, the application 230 includes:

  ◦ an acquisition module 232, which acquires magnetic data (e.g., magnetic field data) from magnetometers 201. In some embodiments, the magnetic data comprise time-series magnetic data; and

  ◦ a processing module 234, which processes the magnetic field data

- data 242 for the magnetic sensing device 200, including but not limited to:

  ◦ magnetic field data 244;

  ◦ device settings 246 for the magnetic field sensing device 200, such as default options, acquisition settings, and preferred user settings; and

  ◦ user settings 248.

In some embodiments, data collected during the data acquisition process is added as data 242.

Although FIG. 2 shows a magnetic field sensing device 200, FIG. 2 is intended more as a functional description of the various features that may be present rather than as a structural schematic of the embodiments described herein. In practice, and as recognized by those of ordinary skill in the art, items shown separately could be combined and some items could be separated.

Each of the above identified executable modules, applications, or sets of procedures may be stored in one or more of the previously mentioned memory devices, and corresponds to a set of instructions for performing a function described above. The above identified modules or programs (e.g., sets of instructions) need not be implemented as separate software programs, procedures, or modules, and thus various subsets of these modules may be combined or otherwise re-arranged in various implementations. In some implementations, the memory 206 stores a subset of the modules and data structures identified above. Furthermore, the memory 206 may store additional modules or data structures not described above. In some embodiments, a subset of the programs, modules, and/or data stored in the memory 206 are stored on and/or executed by a server system, and/or by an external device (e.g., computer system 120).

FIG. 3 is a block diagram illustrating a computer system 120, in accordance with some implementations.

The computer system 120 includes one or more processors 302 (e.g., processing units of CPU(s)), one or more network interfaces 304, memory 306, and one or more communication buses 308 for interconnecting these components (sometimes called a chipset), in accordance with some implementations.

The computer system 120 optionally includes one or more input devices 310 that facilitate user input, such as a keyboard, a mouse, a voice-command input unit or microphone, a touch screen display, a touch-sensitive input pad, a gesture capturing camera, or other input buttons or controls. In some implementations, the computer system 120 optionally uses a microphone and voice recognition or a camera and gesture recognition to supplement or replace the keyboard. The computer system 120 optionally includes one or more output devices 312 that enable presentation of user interfaces and display content, such as one or more speakers and/or one or more visual displays.

The memory 306 includes high-speed random access memory, such as DRAM, SRAM, DDR RAM, or other random access solid state memory devices; and, optionally, includes non-volatile memory, such as one or more magnetic disk storage devices, one or more optical disk storage devices, one or more flash memory devices, or one or more other non-volatile solid state storage devices. The memory 306, optionally, includes one or more storage devices remotely located from the one or more processors 302. The memory 306, or alternatively the non-volatile memory within the memory 306, includes a non-transitory computer-readable storage medium. In some implementations, the memory 306, or the non-transitory computer-readable storage medium of the memory 306, stores the following programs, modules, and data structures, or a subset or superset thereof:

- an operating system 322 including procedures for handling various basic system services and for performing hardware dependent tasks;

- a user interface module 323 for enabling presentation of information (e.g., a graphical user interface for presenting application(s), widgets, websites and web pages thereof, games, audio and/or video content, text, etc.) either at the computer system or at a magnetic field sensing device 200;

- a data receiving module 124 for receiving data (e.g., from a magnetic field sensing device 200);

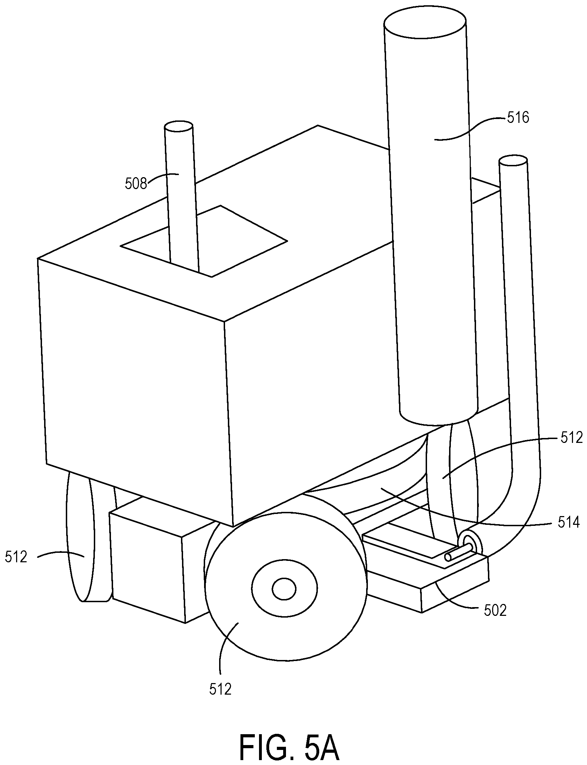

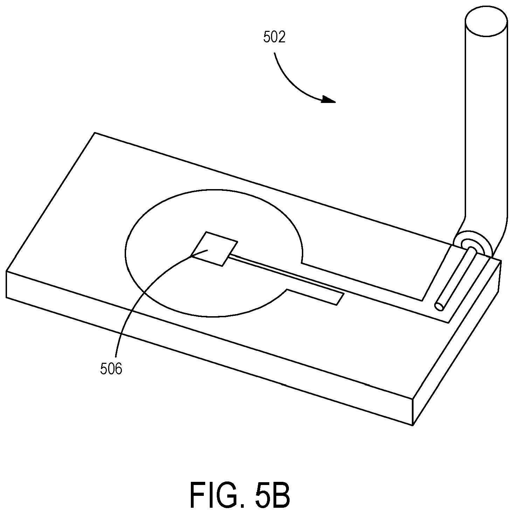

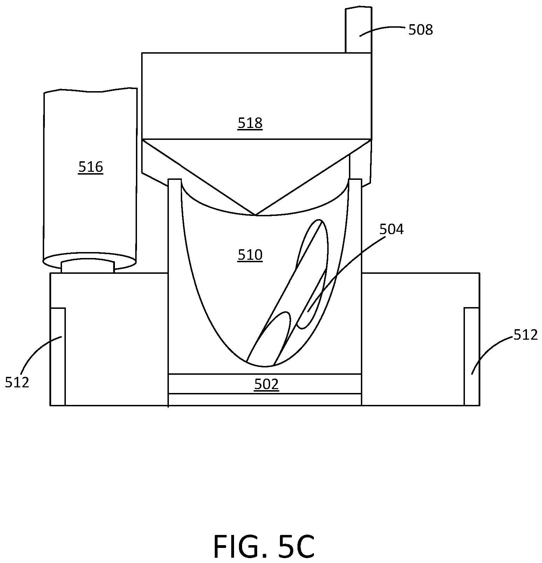

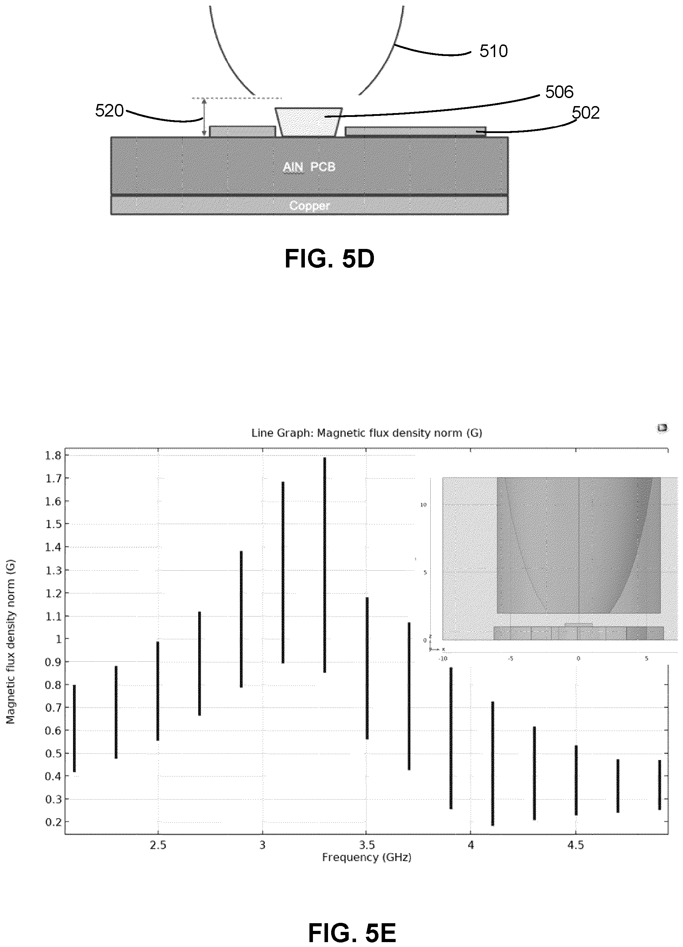

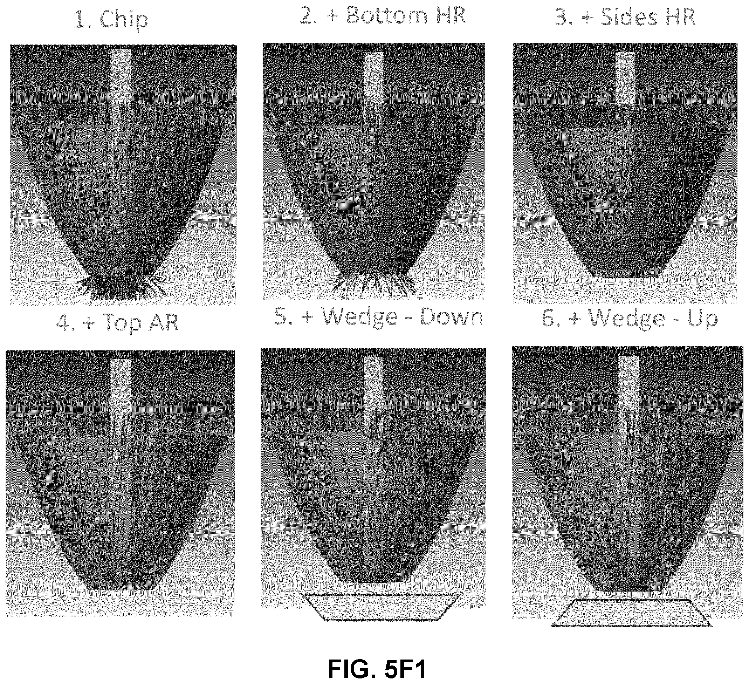

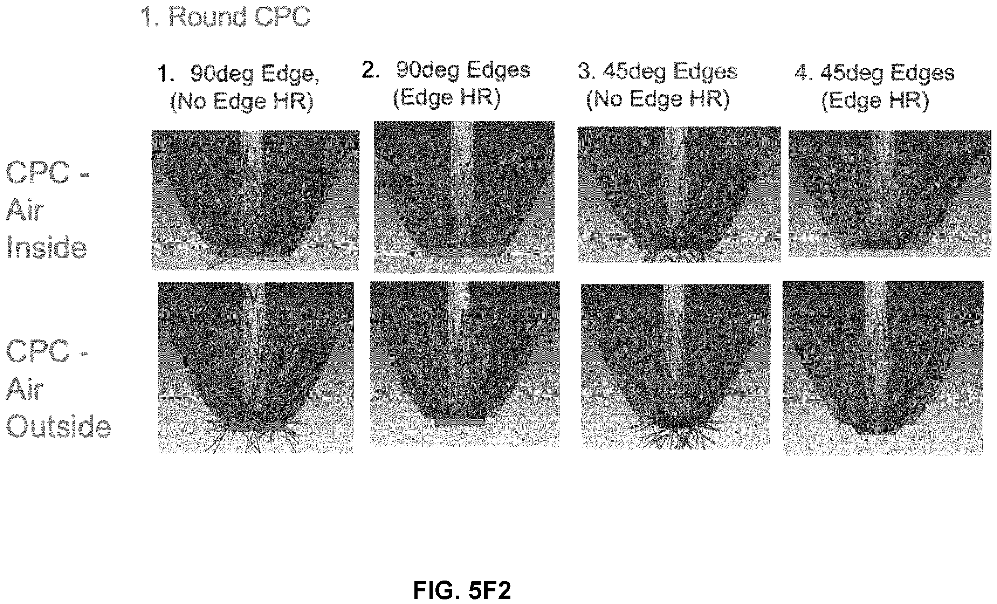

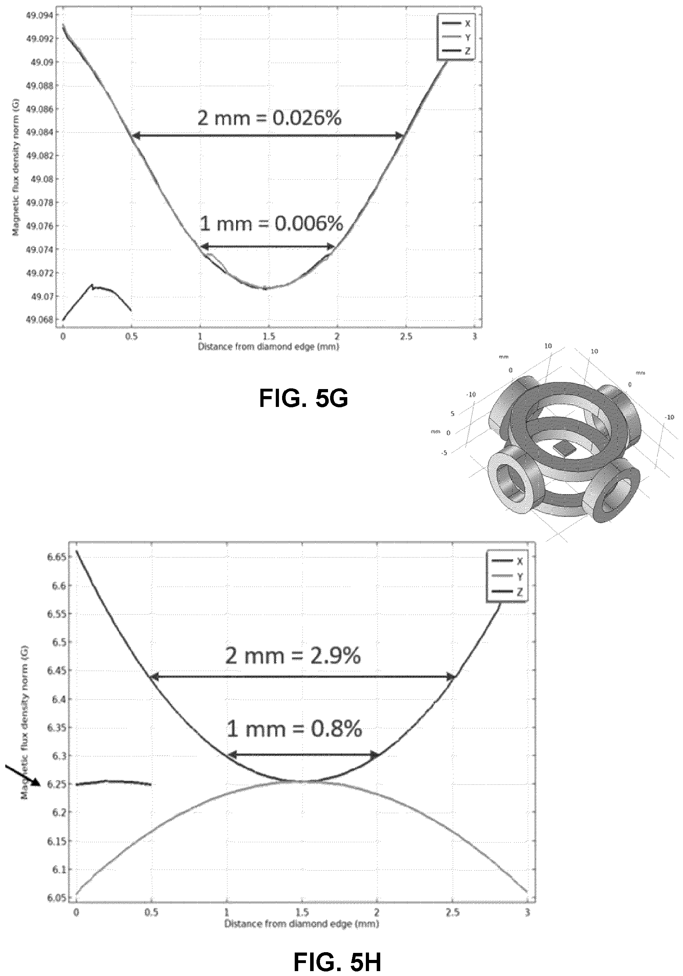

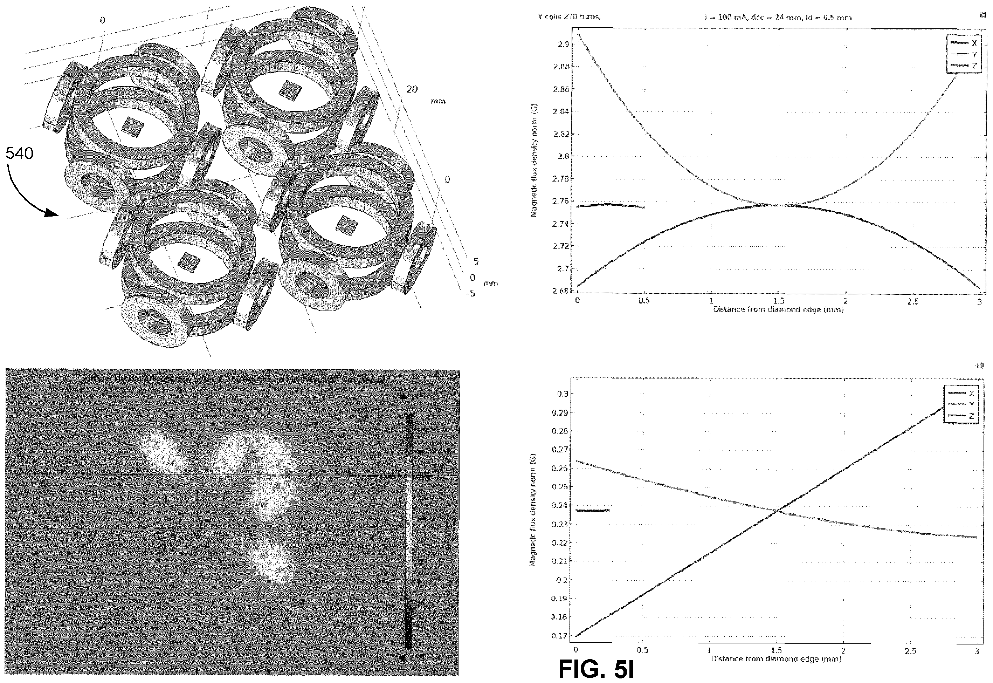

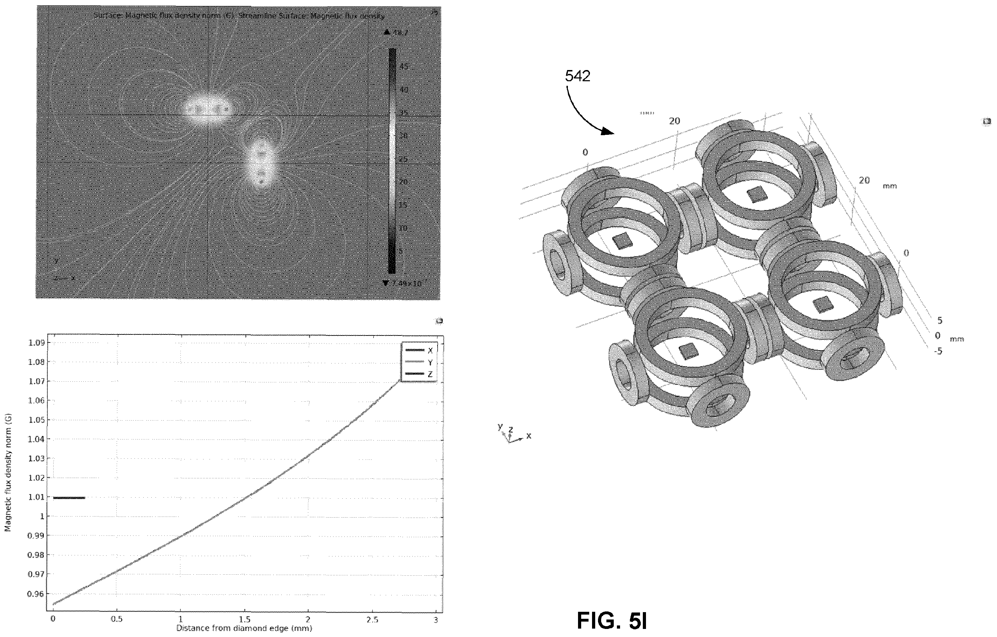

- a data processing module 126 for processing data received by the computer system 120. Further details of data processing are described in FIG. 5 to FIG. 10;

- a training module 324 for generating and/or training models for improving the signal-to-noise ratio of magnetic field data, and for identifying characteristics of the target from the magnetic field measurements. In some embodiments, the training module 324 uses training data 334 to generate and/or train the models. In some implementations, the training data 334 (e.g., training data sets) are generated from measurements from magnetic field sensing devices 200 (e.g., magnetometers 201);

- a database 128, which store data used, received, and/or created by the computer system 120;

In some implementations, the memory 306 includes a machine learning database 130 for storing machine learning information. In some implementations, the machine learning database 130 includes the following datasets or a subset or superset thereof:

- neural network data 328 including information corresponding to the operation of one or more neural network(s), including, and not limited to:

  ◦ machine learning data 330, including training data, annotated characteristics, pretrained image embeddings; and

○ correction data 332 corresponding to data used in conjunction with a backpropagation algorithm or other correction learning algorithms which attempt to minimize error signal at each training iteration.

In some implementations, the computer system 120 includes a device registration module for registering devices (e.g., computer devices, magnetic field sensing devices 200, etc.) for use with the computer system 120.

Each of the above identified elements may be stored in one or more of the memory devices described herein, and corresponds to a set of instructions for performing the functions described above. The above identified modules or programs need not be implemented as separate software programs, procedures, modules or data structures, and thus various subsets of these modules may be combined or otherwise re-arranged in various implementations. In some implementations, the memory 306, optionally, stores a subset of the modules and data structures identified above. Furthermore, the memory 306 optionally stores additional modules and data structures not described above. In some implementations, a subset of the programs, modules, and/or data stored in the memory 306 are stored on and/or executed by the magnetic field sensing device 200.

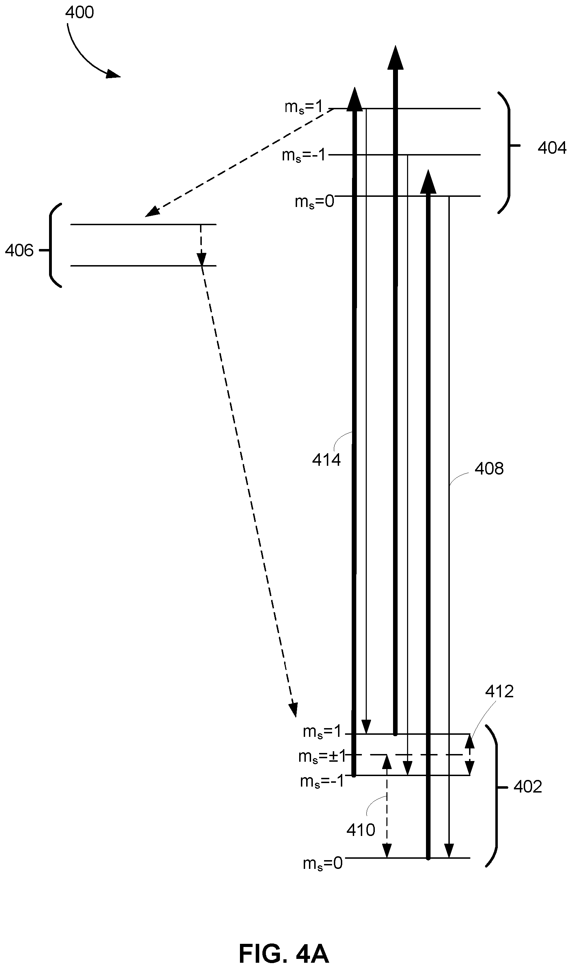

FIG. 4A illustrates an example energy level scheme 400 for a nitrogen vacancy (NV) defect in the negative charge state, in accordance with some embodiments. A nitrogen-vacancy center in diamond (hereinafter "NV diamond") includes a substitutional nitrogen atom in a diamond lattice site next to a carbon vacancy. The NV diamond may have four different crystallographic orientations of a diamond lattice. In a neutral charge state, the NV diamond includes three unpaired electrons, one from the vacancy to each of the three carbon atoms next to the vacancy. There is a pair of electrons between the nitrogen and the vacancy. The NV diamond described herein exists in a negatively charged state and includes an extra electron. Ground level 402 of the NV defect is a spin triplet state, having spin sub-levels of the $m_s=0$ state and the $m_s=\pm1$ state, separated by energy gap 410 or $K=2.87$ GHz in the absence of a magnetic field. In the presence of an external magnetic field, the $m_s=\pm1$ energy levels split by an amount $2g\mu_B B_{NV}$ depicted as a gap 412 in FIG. 4A, where g is the g-factor, $\mu_B$ is the Bohr magneton, and $B_{NV}$ is the component of the external magnetic field along the NV axis.

The NV defect can be optically excited to excited level 404, which also is a spin triplet having an $m_s=0$ state and $m_s=\pm1$ state. Once optically excited into excited level 404, the NV defect can relax primarily through one of two mechanisms: a) through a radiative transition and phonon relaxation to produce a red photoluminescence with a zero phonon line at 1.945 eV or $\lambda_{PL}=637$ nm; or b) through secondary path 406 that involves non-radiative intersystem crossing to singlet states. Optical transitions between initial (e.g. ground level 402) and final states (e.g., excited level 404) have mostly the same spin. A direct transition from an excited triplet state to the ground state emits a photon 408 of red light (e.g., $\lambda_{PL}=637$ nm) corresponding to an energy difference between the energy levels of the excited state and the ground state.

The decay path from the excited state 404 back to the ground state 402 depends on the initial spin sublevel projection. A transition rate from the $m_s=\pm1$ spin states of the excited triplet state 404 to intermediate energy levels 406 is significantly greater than the transition rate from the $m_s=0$ spin state of the excited triplet state 404 to the intermediate energy levels 406. For an electron spin that began in the $m_s=\pm1$ states, there is approximately a 30% chance for the spin to decay non-radiatively through the secondary path, down to the $m_s=0$ state. Also, it may be more probable for the $m_s=\pm1$ states of the excited triplet state 404 to decay non-radiatively via the intermediate energy levels 406. Thus, an overall photoluminescence intensity reduces as the population of the $m_s=\pm1$ states increases relative to the $m_s=0$ states. In other words, photoluminescence intensity provides information about the spin state due to the lower photoluminescence intensity for the $m_s=\pm1$ states compared to the $m_s=0$ spin state. The transition from the intermediate energy levels 406 to the ground state 402 predominantly decays to the $m_s=0$ spin state over the $m_s=\pm1$ spins states. When optical excitation (e.g., green photons 414, depicted as bolded arrows in FIG. 4A) is provided to the system, the NV center may eventually be pumped into the $m_s=0$ spin state of the ground state.

The population of the spin sublevels can be manipulated by the application of a resonant microwave field to the diamond. At a microwave frequency corresponding to the transition energy cost 410 between the 0 and $\pm1$ states, transitions occur between those sublevels, resulting in a change in the level of photoluminescence of the system. Thus, for a spin that is initialized into the $m_s=0$ state, and subsequently transferred to one of the $\pm1$ states by the resonant microwave drive that satisfies the transition energy cost 410, the photoluminescence rate upon subsequent optical illumination will decrease. The photoluminescence intensity (e.g., including photons 408 of red light emitted during the transition from the excited triplet state 404 to the ground state 402) obtained from the $m_s=\pm1$ states by optically stimulating the excited triplet state 404 is less than for the $m_s=0$ spin state because the decay via the intermediate energy level 406 does not result in photoluminescence emissions.

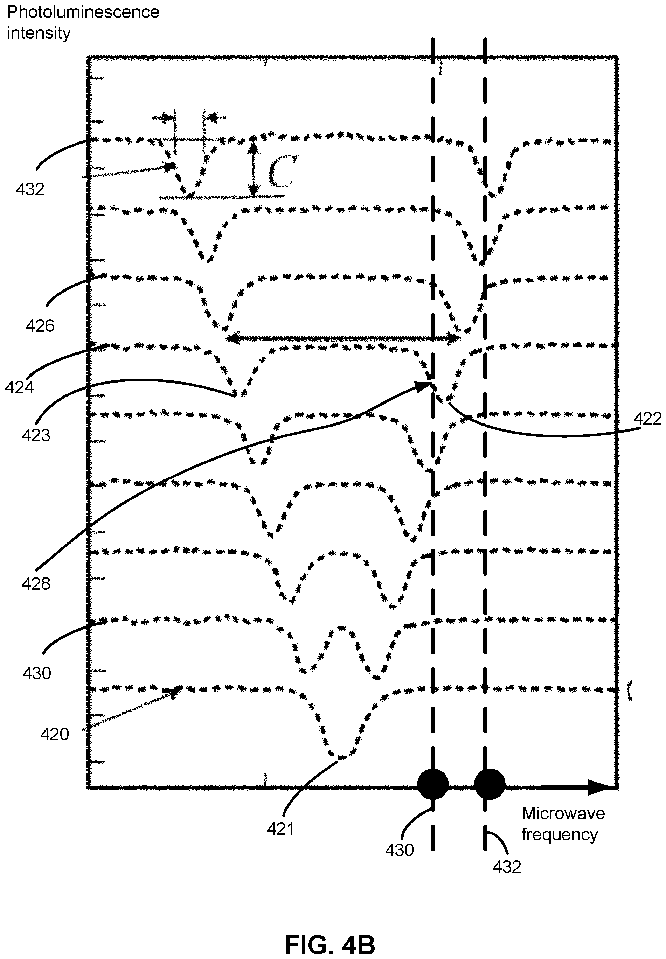

In the absence of a magnetic field, this drop 421 in photoluminescence may be observed by sweeping the microwave frequency across a range of applied microwave frequencies that includes the transition energy between the $m_s=0$ and $m_s=\pm1$ states (e.g., the energy gap 410 in FIG. 4A), as depicted in photoluminescence (PL) intensity line 420 shown in FIG. 4B, which is a plot of photoluminescence intensity versus applied microwave frequency.

When a magnetic field is applied in a vicinity of the NV defect, the degeneracy of the $m_s=\pm1$ spin sublevels is lifted by the Zeeman effect to cause the energy levels of the $m_s=\pm1$ states to shift with respect to each other (e.g., creating the energy gap 412 between the $m_s=1$ state and $m_s=-1$ state, as shown in FIG. 4A), leading to the appearance of two electron spin resonance (ESR) transitions, corresponding to a dip 423 and a dip 422 in PL spectrum 424. The value $\Delta v$ corresponds to the ESR linewidth, typically on the order of 1 MHz and the value C is the ESR contrast. To detect small magnetic fields, the NV transitions may be driven at a point of maximum slope (see, e.g., 428 in FIG. 4B). By setting an appropriate microwave driving frequency and a corresponding magnetic field $B_{NV}$, changes in the photoluminescence may be detected at the point of maximum slope. At the point of maximum slope, small variations in magnetic fields may have the largest changes in photoluminescence intensity. At this point of maximum slope, a detected time-domain change in the photoluminescence allows a time-domain change in magnetic field to be derived. The signal of the time-domain change in the photoluminescence is as $(\partial I_0/\partial B)\times\delta B\times\Delta t$, where $I_0$ is the NV defect PL rate, $\delta B$ is the infinitesimal magnetic field variation, and $\Delta t$ is the measurement duration, much smaller than the timescale on which the magnetic field changes. The procedures for such derivations is outlined, for example, in U.S. Patent Application 17/472,209, the contents of which are incorporated herein by reference. An NV diamond thus provides a defect that functions as a spatially resolved (e.g., atomic-sized spatial resolution) magnetic field sensor. To improve sensitivity, a collective response of an ensemble of NV defects may be detected, such that the collected PL signal is magnified by the number N of the sensing spins and therefore improves the shot-noise limited magnetic field sensitivity by a factor of $1/\sqrt{N}$.

A resonant microwave field can be applied to the diamond to manipulate populations of the spins in the $m_s=\pm1$ states and the $m_s=0$ states. At a microwave frequency matching the transition energy between the $m_s=0$ and $m_s=\pm1$ states, for example, a microwave excitation that matches the energy gap, transitions occur between those states and change a photoluminescence level of the system. For a spin state initialized into the $m_s=0$ state and excited to one of the $m_s=\pm1$ states by the resonant microwave drive, photoluminescence rates decrease after subsequent optical excitations.

FIG. 4B shows PL intensity plots 430, 424, 426, and 432 and the effect of increasing an external magnetic field $B_{NV}$ on an energy separation between the two dips in each photoluminescence plot. For example, plot 432 has the largest external magnetic field $B_{NV}$ and an energy separation between the two dips is the largest among plots 430, 424, 426, and 432.

The energy separation in photoluminescence plots 430, 424, 426, and 432 in FIG. 4B is observed when the magnetic field is applied along one of the symmetry axes of an NV center (e.g., along one of the four symmetry axes of the NV center. An advantage of using NV diamond sensors for vector magnetometry is the ability to extract additional directional information (e.g., vector information) using a known magnetic field that is aligned, or has a component along one or more of four crystallographic orientations set by the tetrahedral symmetry of the diamond lattice.

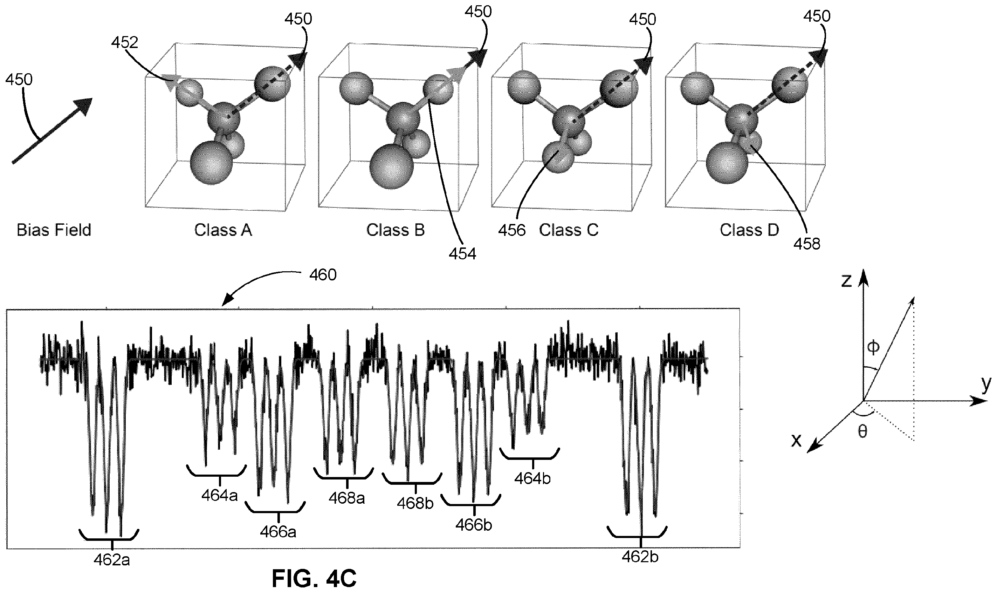

FIG. 4C shows signal spectrum 460 displaying photoluminescence (PL) signal from an ensemble of NV centers in a bias magnetic field B. The spectrum 460 in FIG. 4C depicts eight different clusters of dips, arranged in four distinct pairs of clusters, in accordance with some embodiments. A first pair of clusters 462a and 462b may correspond to the dips 422 and 423 shown in FIG. 4B. Each cluster includes subfeatures forming three dips which are due to NV hyperfine structures. In some embodiments, a spectrum from a NV diamond sensor includes 24 dips (or peaks), arranged in four pairs of clusters, each cluster being a collection of three dips, as shown in FIG. 4C. As explained in FIG. 4B, the energy separation between the two dips 422 and 423 is proportional to the magnetic field (e.g., $B_{NV}$) that causes the Zeeman effect (e.g., the energy separation is $2g\mu_B B_{NV}$). The four different pairs of clusters have different energy separations from one another due to differences in local magnetic fields experienced by NV diamond. The dips having the largest energy separation also experiences the largest local magnetic field $B_{NV}$. In some embodiments, magnetic fields having only an x or y component would not project onto two of the NV classes in the system 550 and their resonances do not shift in the presence of an additional magnetic field (e.g., oriented along the z-direction). For the remaining two other NV classes, one will experience a slight increase in the projected magnetic field along its symmetry axis and the other will decrease. For magnetic fields having only an x or y component will have no projection onto two of the NV classes and their resonances will not shift in the presence of the additional field. However, for the other two NV classes, one will experience a slight increase in the projected magnetic field along its symmetry axis and the other will decrease.

The NV diamond yields four different classes of signals for each of the four crystallographic orientations set by the tetrahedral symmetry of the diamond lattice. In some embodiments, a bias field 450 having a specific three-dimensional orientation is applied in a vicinity of the NV diamond. Arrows 452, 454, 456, and 458 depict respective vectors (or spin axes) pointing from a substitutional nitrogen to a vacancy in respective classes of NV diamond center. In some embodiments, the first pair of clusters 462a and 462b corresponds to magnetic signals detected along the arrow 452 shown in Class A; a second pair of clusters 464a and 464b corresponds to magnetic signals detected along the arrow 454 shown in Class B; a third pair of clusters 466a and 466b corresponds to magnetic signals detected along the arrow 456 shown in Class C; a fourth pair of clusters 468a and 468b corresponds to magnetic signals detected along the arrow 458 shown in Class D. As shown in FIG. 4C, the bias field 450 is most aligned with Class B, the arrow 454 is nearly collinear with the bias field 450. As a result, in the example illustrated in FIG. 4C, the bias field 450 would maximally shift Class B and separate it from the other three classes. For example, changes to the bias field 450 (e.g., an amplitude) would be most strongly reflected in the signals from the pair of clusters associated with Class B (e.g., the second pair of clusters 464a and 464b). While all classes are fundamentally identical, the NV class having a spin axis that makes the smallest angle with the test field vector of the test field to be sensed is optionally used in some embodiments. In some embodiments, the class (e.g., from among Classes A-D) that is most aligned with an unknown magnetic field (e.g., the magnetic field to be characterized, the magnetic field emanating from a structure; the magnetic field emanating from a biological structure, or the magnetic field emanating from a subject's heart or brain) is maximally separated from the other three classes using a suitably selected bias field. In other words, a bias field is selected to align with a particular class to draw signals (e.g., the pair of clusters with dips) associated with that class out from the rest.

In some embodiments, the bias field is arranged to contribute to each of the four classes so that the four pairs of clusters can jointly provide vector information about the unknown magnetic field to be sensed (e.g., the magnetic field to be characterized, the magnetic field emanating from a structure; the magnetic field emanating from a biological structure, or the magnetic field emanating from a subject's heart or brain).

To extract information from vector magnetometry, the following equations are used:

$$
\begin{bmatrix} \Delta\nu_\lambda \\ \Delta\nu_\chi \\ \Delta\nu_\varphi \\ \Delta\nu_\kappa \end{bmatrix}_{\text{sens}} = \mathbf{A} \begin{bmatrix} B_x \\ B_y \\ B_z \end{bmatrix}_{\text{sens}},
$$

The shifts in frequencies from each of the four classes of signals (e.g., $\Delta\nu_\lambda$, $\Delta\nu_\chi$, $\Delta\nu_{\theta\phi}$, $\Delta\nu_\kappa$) sensed by the magnetic sensor, is converted into the actual three-dimensional magnetic field signal ($B_x$, $B_y$, $B_z$, or the lab-frame magnetic field components) of the magnetic source by matrix A.

$$
\mathbf{A} = \begin{bmatrix} \frac{\partial\nu_\lambda}{\partial B_x} & \frac{\partial\nu_\lambda}{\partial B_y} & \frac{\partial\nu_\lambda}{\partial B_z} \\ \frac{\partial\nu_\chi}{\partial B_x} & \frac{\partial\nu_\chi}{\partial B_y} & \frac{\partial\nu_\chi}{\partial B_z} \\ \frac{\partial\nu_\varphi}{\partial B_x} & \frac{\partial\nu_\varphi}{\partial B_y} & \frac{\partial\nu_\varphi}{\partial B_z} \\ \frac{\partial\nu_\kappa}{\partial B_x} & \frac{\partial\nu_\kappa}{\partial B_y} & \frac{\partial\nu_\kappa}{\partial B_z} \end{bmatrix}_{\vec{B}_0, D, \vec{\mathcal{M}}_z},
$$

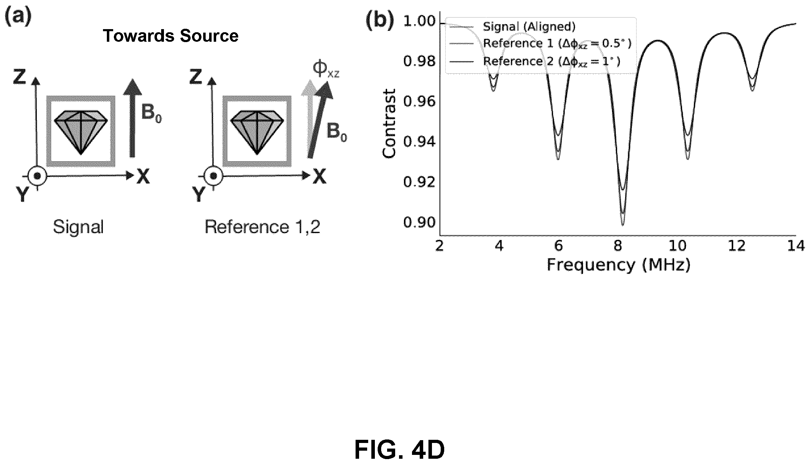

The matrix A is formed by linearizing a corresponding Hamiltonian about the bias field $B_0$ FIG. 4D shows examples of magnetic signals in accordance with some embodiments.

In some embodiments, the bias field $B_0$ has a non-negligible component transverse to each NV symmetry axis, and A is determined numerically by evaluating the partial derivatives using a step size of

$$
\delta B_x = \delta B_y = \delta B_z = \frac{h}{g_e \mu_B} \cdot 10\,\text{Hz}
$$

In some embodiments, for simultaneous vector measurements (SVM), the eight NV resonances are selected to be non-degenerate (individually addressable with microwave fields). Various criteria influence the choice of bias magnetic field ($B_0$) orientation and magnitude. For example, in some embodiments, NV resonances are separated from each other to minimize cross-talk. In some embodiments, a separation of 15 MHz or more is sufficient for a 60 dB suppression of axis cross-talk. In some embodiments, third-order inter-modulation products of the applied microwave drive frequencies do not overlap with any of the NV resonances. In some embodiments, the applied drive frequencies do not overlap with any NV resonances within 15 MHz. In some embodiments, non-zero projections of the bias magnetic field fall onto all NV orientations. In some embodiments, a magnetic field of 5G is sufficient given typical strain/electric field magnitudes.

In some embodiments, in a second mode of operation, NV orientations are overlapped using a bias magnetic field. For example, all four NV orientations (corresponding to Class A - Class D) are overlapped using a bias magnetic field. In some embodiments, the magnetic sensing system is sensitive to magnetic fields along the same direction as the bias magnetic field, extending along the z-axis (e.g., as shown in the top-down view of FIG. 4D). The bias field configuration may suppress responses to magnetic fields along the x- and y-directions. In such a first mode of operation, all four NV orientations are overlapped using a bias magnetic field. Gradiometry is a technique for operating a magnetometer in an unshielded environment, in accordance with some embodiments. Gradiometry is able to suppress ambient magnetic noise which is common-mode between two or more sensors separated by some distance. FIG. 4D also shows a signal sensor (e.g., "Signal") having a bias magnetic field $B_0$ that is perfectly aligned with the z-direction. FIG. 4D shows, as an example, the bias field for the Reference 1 (Reference 2) sensor head that is mis-aligned by an angle $\phi_{XZ} = 0.5°$ ($\phi_{XZ} = 1°$) in the XZ-plane.

The resulting signals for the three cases are shown in FIG. 15(b). The small misalignment of Reference 1 ($\phi$XZ = 0.5∘) has a negligible impact on the linewidth, but an observable change in the depth of the signal features, assuming sufficient signal to noise ratio. The effect is exaggerated for the larger misalignment of Reference 2.

In some embodiments, a bias field orientation is primarily along the z-direction. Due to the crystal symmetry, similar results can be obtained for fields mostly along the x- or y-directions as well. In some embodiments, an orientation of [theta, phi] = [19∘, 20∘] is used, where phi corresponds to the angle from the z-direction and theta is the angle from the x-direction. In some embodiments, the definitions of x and y are arbitrary as long as they are perpendicular to the diamond faces and each other.

In some embodiments, the bias field magnitude is minimized for patient safety, sensor power consumption, and sensor cross-talk. However, as the bias field magnitude is reduced, the sensor will become more sensitive to mis-alignments due to construction tolerances, Earth's magnetic field (0.5G), or nearby objects/sensors. In some embodiments, for a bias field of 80 G), the tolerance on the alignment is quite robust; perturbations of up to 10∘ in theta or phi (∼ 5 G) do not compromise the sensor. As $|B_0|$ decreases, performance criteria are satisfied when the system is properly aligned, but the robustness against misalignment is degraded. For example, increasing phi may result in inter-modulation products overlapping with NV resonances.

One of the major challenges in detecting small signals (e.g., cardiac signals, or other magnetic signals from weak sources) in magnetically unshielded environments is the extremely low signal-to-noise ratio of the small signals. For example, the amplitude of the small signals may be very small compared to magnetic interference from sources external to the magnetic source of interest (e.g., the heart for cardiac signals). For example, the strength of the Earth's magnetic field is approximately 50 microTeslas, which is about a million times larger in amplitude than the expected signal of the heart's magnetic field when a magnetic field sensing device is positioned just outside the chest of a patient. Clinical environments are often magnetically noisy with electrical equipment radiating magnetic interference not only at the power line frequency and its harmonics, but also across a wide frequency range.

FIG. 5A-5J illustrate miniaturized magnetic sensing systems that are configurable to operate in vector magnetometry mode, in accordance with some embodiments. In some embodiments, the vector magnetometry system includes a miniaturized sensor head. The miniaturized sensor head may have improved microwave (MW) delivery, increased optical collection efficiency (e.g., including the use of high-reflectivity and/or anti-reflective coatings), and/or a reduced noise floor measured on the diamond systems.

FIG. 5A-5C show a sensor head unit 500 that includes a microwave resonator 502 (hereinafter also sometimes referred to as RF PCB), in the center of which is placed the NV diamond sensor 506. Pairs of bias coils 512 are placed in substantially the same horizontal plane as the NV diamond sensor 506 (e.g., along the x, and y directions). The sensor head unit 500 also includes RF connector 516 for the bias coils. A larger pair of bias coils 514 (e.g., only the top element of the pair is visible in FIG. 5A) is placed above and below the NV diamond sensor, along the z-direction. Excitation light 508 (e.g., light having a wavelength between 500-550 nm) is incident on the NV diamond sensor 506 after passing through an opening 504 in the compound parabolic connector (CPC) 510. The photoluminescence (e.g., red photoluminescence having a wavelength between 600-650 nm, e.g., 637 nm) emitted by the NV diamond sensor is detected at a sensor (e.g., photodiode) 518.

FIG. 5D shows an example cross-sectional view of a portion of the sensor head unit, in accordance with some embodiments. In some embodiments, the CPC 510 is spaced apart by a gap 520 from the top surface of the RF PCB. For example, the gap 520 is greater than 0.1 mm (e.g., greater than 0.5 mm, about 1 mm, about 2 mm). In some embodiments, the gap 520 helps to reduce the impact caused by the presence of CPC 510 on the RF PCB, and increases the performance of the RF PCB. Placing the CPC 510 with the gap 520 also increases the optical collection efficiency of the green photoluminescence emitted by the NV diamond 506. In some embodiments, applying a layer of thermal epoxy between the AIN PCB and the copper heat sink helps to relieve strain of connector components on the copper. The use of an integral piece of AIN PCB results in fewer parts and simplifies assembly.

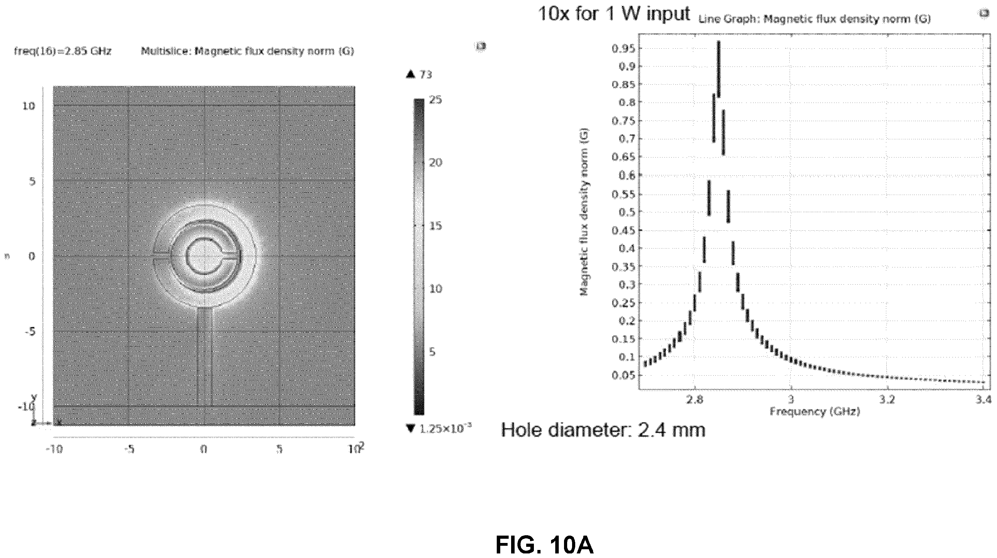

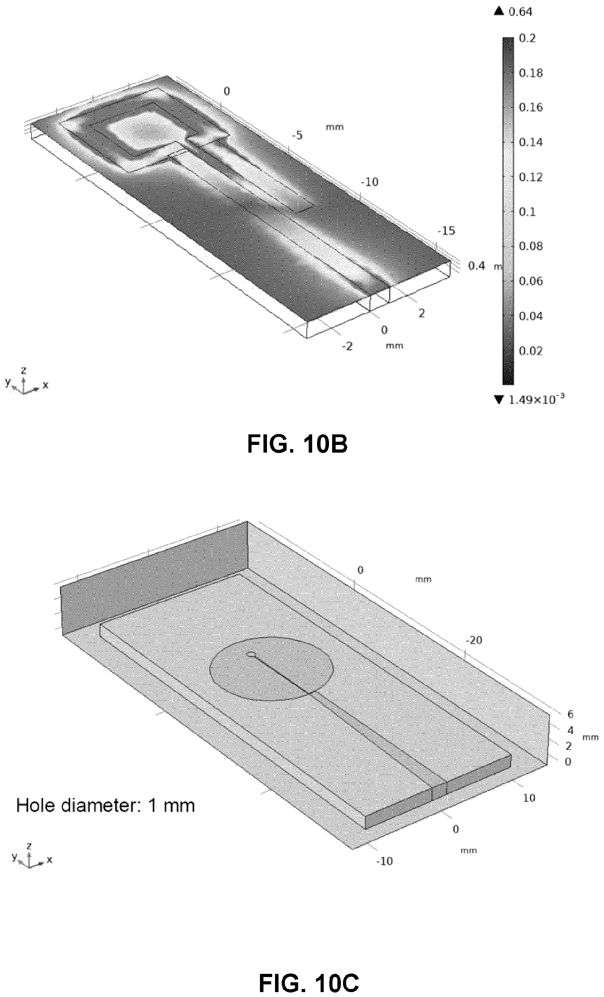

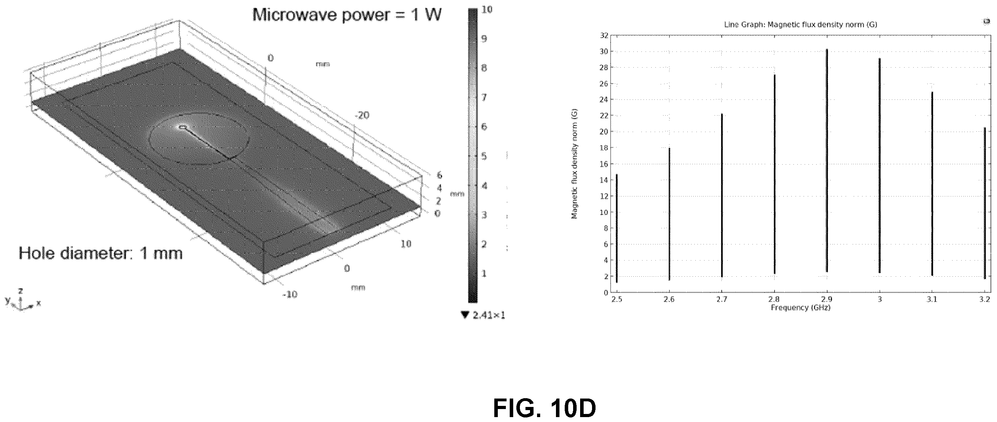

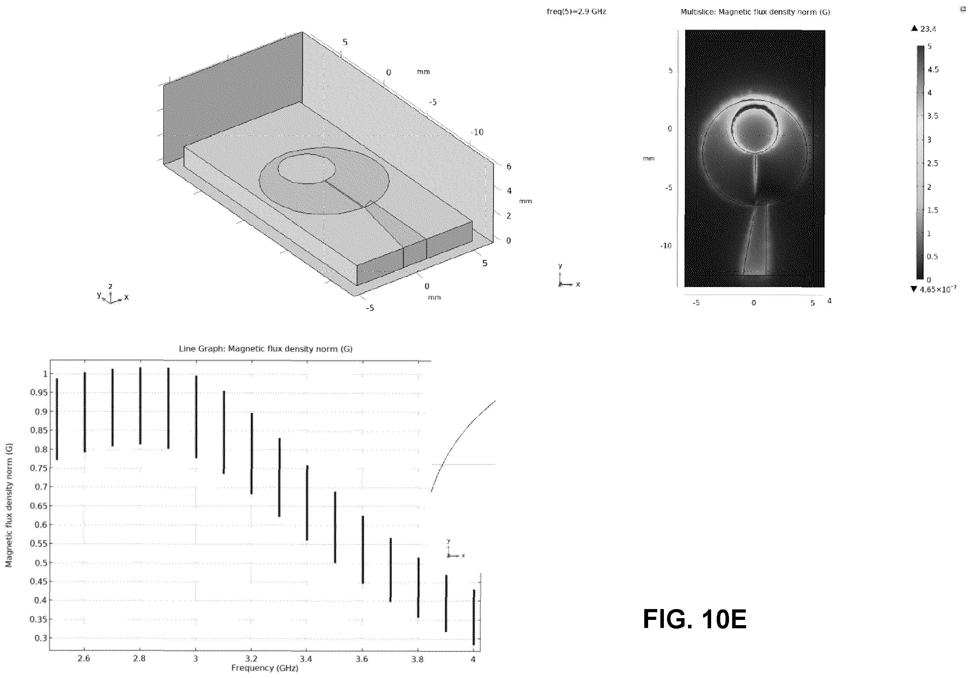

For vector magnetometry, a bandwidth for the microwave resonator loop is to be about 400 MHz for a bias field $B_0$ of about 80 G. The sensor head unit benefits from having the highest field perturbation per watt of microwave power. While high Q resonators give large fields, their bandwidth would be narrower compared to resonators having lower Q. For example, a Bayat split ring resonator (e.g., in FIG. 10A) has a high Q. A Sasaki loop/hole (e.g., FIGS. 10D and 10E) has a medium Q that is lower than that of the Bayat split ring resonator. A simple loop (e.g., FIG. 10 B) has a low Q.

FIG. 5E shows the magnetic flux density over the frequency range of 2 to 5 GHz for a metal CPC having a 1 mm gap in a sensor head unit that uses a AIN heat sink.

FIG. 5F1 shows variations in the amount of photoluminescence signal (e.g., red photoluminescence) collected based on different types of optical treatments, in accordance with some embodiments. In a first variation, a CPC is used to collect the red photoluminescence from the NV diamond 506. In a second variation, in addition to the CPC, a high-reflective coating is applied on the bottom surface of the NV diamond 506 to redirect the red photoluminescence back toward the photodetector at the top end of the CPC. In a third variation, in addition to the CPC, a high-reflective coating is applied on the side surfaces of the NV diamond 506 to redirect the red photoluminescence toward the photodetector at the top end of the CPC. In a fourth variation, in addition to the CPC, an anti-reflection (AR) coating is provided on a surface of the NV diamond 506 facing the photodetector. In a fifth variation, in addition to the CPC, the NV diamond 506 is shaped as a wedge with the longer horizontal surface being closer to photodiode. In a sixth variation, in addition to the CPC, the NV diamond 506 is shaped as a wedge with the shorter horizontal surface being closer to photodiode. In some embodiments, a significant improvement in the collection efficiency (e.g., about two times) is observed between the first and second variations.

FIG. 5F2 shows variations in the amount of photoluminescence signal (e.g., red photoluminescence) collected based on different types of optical treatments, in accordance with some embodiments. The top row shows variations in which the NV diamond 506 is placed within the CPC, while the lower row shows variations in which the NV diamond 506 is placed outside of the CPC (e.g., with a gap 520, such a gap of 0.5 mm, or a gap of 1 mm). In a first variation, the NV diamond 506 has side edges that are oriented at angles substantially equal to 90° (between 85° to 95°) and without any high-reflective (HR) coating on the side faces. In a second variation, the NV diamond 506 has 90° side edges and high-reflective (HR) coating on the side faces. In a third variation, the NV diamond 506 has side edges cut at 45° and without any high-reflective (HR) coating on the side faces. In a fourth variation, the NV diamond 506 has side edges cut at 45° and high-reflective (HR) coating on the side faces.

FIG. 5G shows the magnetic flux density along the x and y directions as a function of distance from the edge of the NV diamond 506 that is placed between Z-coils 514. In some embodiments, the magnetic flux density varies by a negligible amount (e.g., about 0.026%) within 2 mm from the edge of the NV diamond 506, and by an even smaller amount (e.g., about 0.006%) within 1 mm from the edge of the NV diamond 506. In some embodiments, such a uniform magnetic flux density is produced by a pair of Z-coil 514 having hundreds of turns, and through which a current of between tens to hundreds of mA runs.

FIG. 5H shows the magnetic flux density along the x and y directions as a function of distance from the edge of the NV diamond 506 that is placed x and y-coils 512. In some embodiments, the magnetic flux density varies by a larger amount (e.g., about 2.9 %) within 2 mm from the edge of the NV diamond 506, and by a smaller amount (e.g., about 0.8%) within 1 mm from the edge of the NV diamond 506. In some embodiments, the magnetic flux density shown in FIG. 5H is produced by a x coils and y coils each having between hundreds of turns, through which a current of between tens to hundreds of mA runs. In some embodiments, the wire is an AWG 32 wire, an AWG 40 wire, or an AWG 28 wire. In some embodiments, ~ 12-25 G in the x-y direction may be used for vector magnetometry. In some embodiments, instead of providing only adjustable bias coils, a combination of one of more permanent magnets and the bias coils are used.

FIG. 5I shows an arrangement 540 of four sensor head units and with respective sets of bias coils. The arrangement 540 leads to bias interference when the sensor units are spaced by about several centimeters apart, and the interference field at 100 mA is about 8%.

FIG. 5J shows an arrangement 542 of four sensor head units and with respective sets of bias coils. The arrangement 542 also leads to bias interference that is larger than that from the arrangement 540 shown in FIG. 5I.

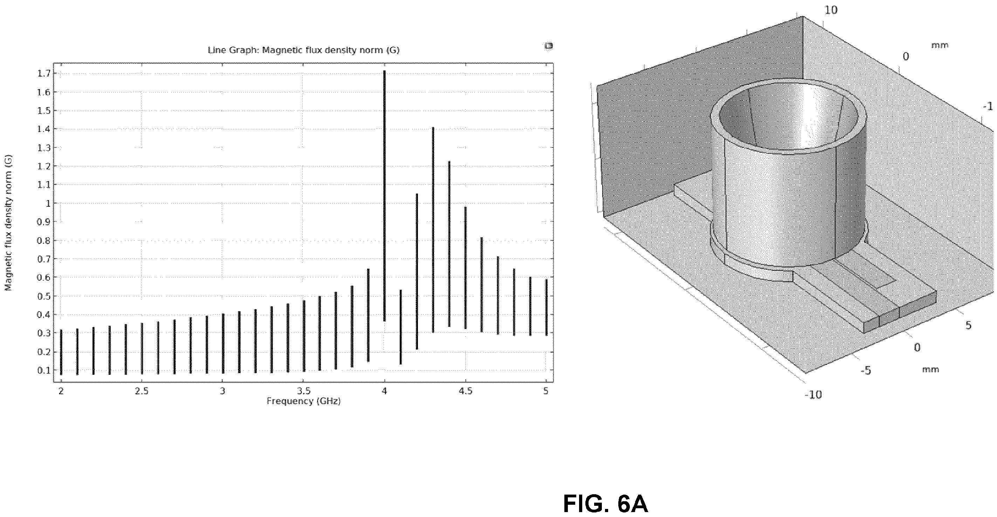

FIG. 6A shows the magnetic flux density of a sensor head unit over the frequency range of 2 to 5 GHz for a sensor head unit that has an aluminum CPC placed in close proximity to a copper heat sink (e.g., without a gap between the CPC and the RF PCB). In some embodiments, such a placement disrupts the resonance structure.

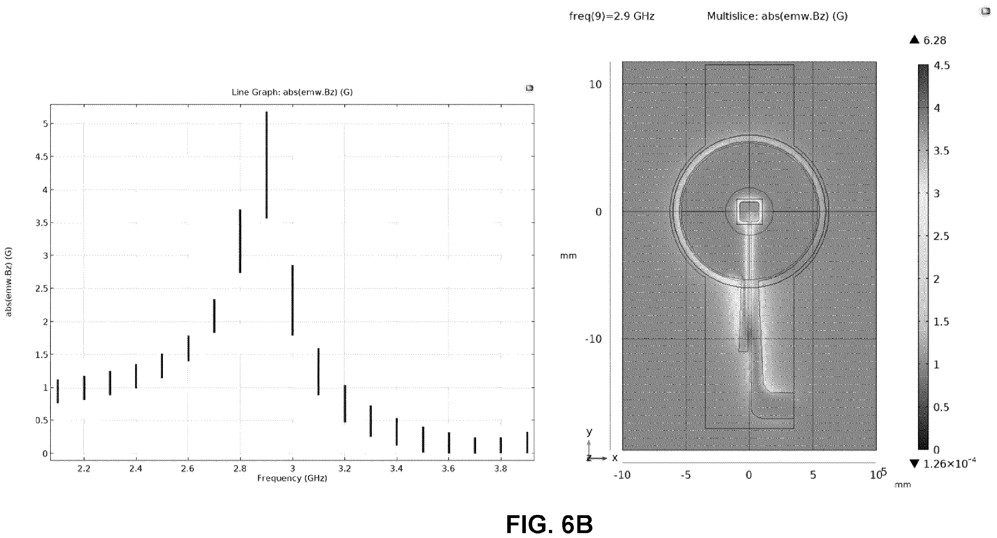

FIG. 6B shows the magnetic flux density of a sensor head unit over the frequency range of 2 to 4 GHz for a sensor head unit that has a CPC placed at a 0.5 mm gap between the CPC and the NV diamond 506. The NV diamond 506 has edges that are cut at 45°. and the AIN RF PCB includes a square opening that has a side length of 1.5 mm.

In cases where the SMA adapter is soldered onto the microwave PCB, the alignment of the microwave delivery PCB with the rest of the fixture may impact the vector magnetometry system's ability to tune the resonance of the MW PCB, which may in turn impact the delivery of microwave to diamond sensor. For example, the MW resonance may be blue-shifted or red-shifted, and be detuned from the expected MW resonance frequency (e.g., by tens or hundreds of MHz). In some scenarios, strains due to the soldering of the SMA adapter may cause mechanical failures (e.g., cracks) to the PCBs that result in further misalignment.

By comparing the noise floor recorded by the sensor head when the microwave delivery is turned off and when the microwave delivery is turned on, whether the recorded noise floor is due to magnetic field noise can be determined. If the noise floor is not affected when the microwave delivery is turned off, then the recorded noise is not magnetic field noise. A determination is also made whether the noise level increases with increased laser power. In scenarios where the reference photodiode (PD) is saturated (e.g., by a laser hotspot), the noise level would increase with increased laser power, contrary to theoretical prediction and empirical observations that the noise level generally decreases with increased laser power. To reduce the intensity of the laser light hitting the PD, appropriate lens(es) can be introduced in the system to enlarge the spot of the laser spot on the PD, or by introducing a diffuser or filter before the reference PD.

In some embodiments, a gain on the RF output is also adjusted (e.g., reduced) to ensure that an output of an autobalancing board is not clipped at the powers the vector magnetometry system typically uses (e.g., 50 mV at 1W laser setpoint, 100 mV, 200 mV or 300 mV at 3 W laser setpoint, or >300 mW, > 400 mW, -480 mW, -550 mW before the sensor head, and other similar powers at which clipping would likely not be an issue in the single-axis mode either). In some embodiments, the usability of the collection electronics is improved by connectorizing the photodiodes and enclosing the board in a metal box with the appropriate connectors.

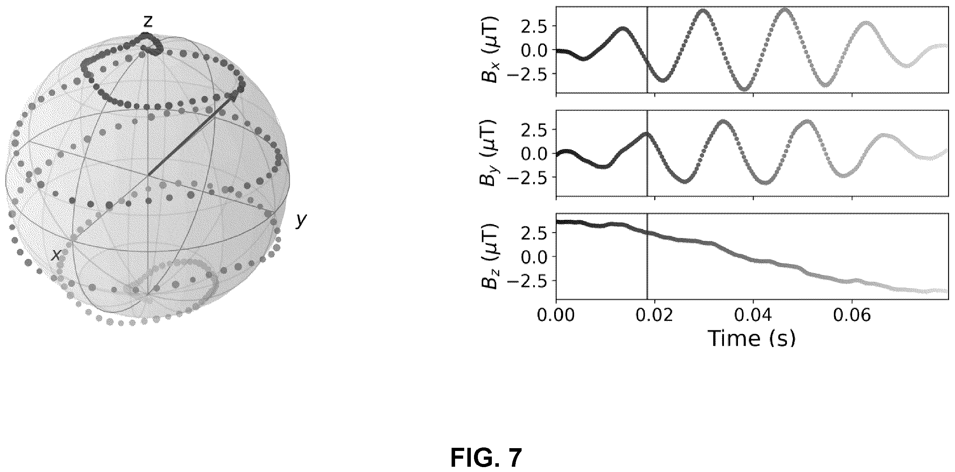

In some embodiments, simultaneous vector magnetometry (SVM) is performed without hyperfine driving (HFD) and without double-quantum (DQ). FIG. 7 shows SVM data reconstructed in three dimensions on the left, with one selected data point, with a marked vector pointing to it. This selected data point corresponds to the data at the time marked on the right by the vertical line 804.

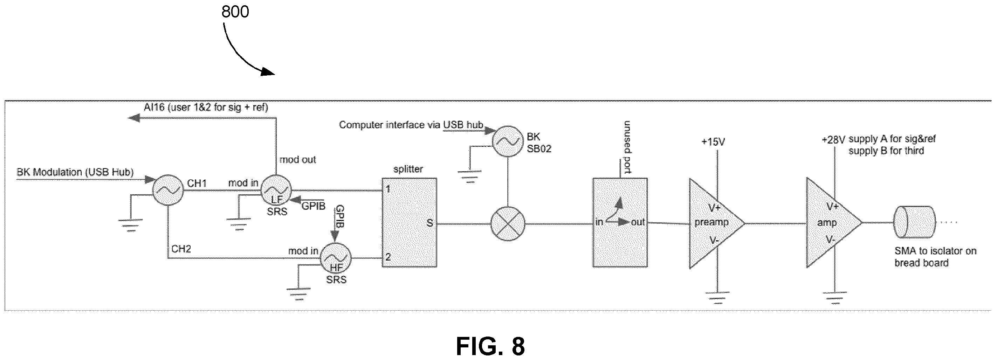

FIG. 8 shows an example of MW delivery chain 800 that includes a circuit displayed for applying microwave to the NV centers. In some embodiments, module 800 allows single-axis magnetometry mode to operate with hyperfine driving HFD and double quantum (DQ).

In some embodiments, the sensing system is used for applications in which simultaneous vector magnetometry is beneficial (e.g., more complete spatial or field data), if a sensitivity requirement of the measurements is less than a threshold amount (e.g., >500 pT/√Hz or worse, >200 pT/√Hz or worse, >100 pT/√Hz or worse, -100 pT/√Hz or worse, or >50 pT/√Hz or worse), if a spatial resolution requirement is less stringent than a threshold resolution, or if the sensing system is used for a quantum sensing lab curriculum.

When the magnetometry system is used in the vector mode of operation, the measured signal is split into multiple groups of signals (e.g., four families of signals). Assuming the contrast is evenly divided between the families, the noise floor would increase by the number of groups of signal splits (e.g., 4 times) because the shot-noise limited sensitivity is inversely proportional to contrast. The PSD level is inversely proportional to the square root of photon counts, so to compensate for the reduction in sensitivity in the vector configuration (e.g., 4 times worse) compared to the for a single-axis mode of operation, the photon count rates would need to improve by the square of the reduction (e.g., 16 times).

In some embodiments, instead of providing a long tail to the microwave (MW) resonators to allow flexibility in the resonance frequency and to ensure sufficient space on the boards to customize the frequency for respective applications, different PCBs with different tail lengths with a narrower distribution centered around the theoretical design length are provided. For example, such PCBs would obviate the need to severe the metal tail (e.g., removing the metal from the metal tail, and/or using a dremel to remove the metal from the metal tail) to tune the microwave resonance frequency. In some embodiments, to get an accurate measurement of the resonance, the sensor head, including the diamond sensor, may need to be fully assembled due to the shifting in resonance (e.g., by more than 50 MHz, by more than 200 MHz, by more than 300 MHz, by more than 400 MHz) between the bare resonator and the fully assembled sensor head.

In some embodiments, the microwave PCB is centered and aligned to the rest of the fixture (e.g., with tight tolerances). In scenarios where the microwave PCB is thermally and electrically grounded to the heatsink with a conductive epoxy, soldering at room temperature after securing the PCB in place may become more challenging. In some embodiments, potting the SMA helps to relieve some strain instead of soldering the SMA cable to the microwave PCB, which may apply too large torque to the PCB.

In some embodiments, the microwave PCB is connectorized to make the sensor head more mechanically stable, for example, by using a SMA connector such as a MCX to SMA adapter or a MMCX to SMA adapter. In some embodiments, end-launch types of these connectors that fit spatially on the sensor heads and with the sensor array spacing are selected.

In some embodiments, crimped picoblades are used as coil connectors. Crimping such picoblades instead of soldering them helps to minimize the volume of the solder joint in the picoblade that may interfere with proper engagement with the connector. When not properly relieved, strain from the cable connecting the coils to the drivers may be sufficient to break the magnet wire or to disconnect the picoblade connectors. In some embodiments, strain on the coil connectors is relieved, for example, by epoxying the magnet wire side of the connector to the side of the sensor head.

In some embodiments, 60 Hz noise from the detectors may be reduced by isolating the SMA connecting the photodiode to the board with a braided shield.

The collection efficiency may be impacted by the presence of apertures (e.g., a hole in the side of) in the compound parabolic concentrator (CPC) or the gap 520 between the diamond chip and the bottom of the CPC. In some embodiments, the CPC is polished to a reduce a surface roughness. In some embodiments, the collection efficiency is increased from an uncoated diamond chip when the diamond chip is provided with both an anti-reflective (AR) coating on top and a high-reflectivity (HR) coating, each having sufficient adhesion (e.g., to maintain adhesion during an epoxying process) on the sides and back of the diamond chip.

In some embodiments, increasing the intensity of the excitation laser spot (e.g., the spot from green excitation light) on the diamond (e.g., an excitation intensity of between 1-10, 2-8, or 3-5 $\mu W/\mu m^2$ can improve the performance of the system ). For example, the intensity of the excitation laser spot can be increased by introducing appropriate lens(es) before the excitation laser spot reaches the diamond sensor, or increasing the excitation laser power.

Cross-talk between the measurement axes in vector magnetometry measurements introduces errors into the measurements. Cross-talk occurs, for example, when a sinusoid waveform is driven on a coil pair nominally aligned with a certain lab frame axis, and while there is strong signal from the lab frame magnetometry data on that axis, the other two axes may pick up some of that signal as well.

In some embodiments, the source of the cross-talk is first determined: whether it is from a physical misalignment of the magnetic coils or the fields from the coils, whether the signal from one coil is inducing a current on the others, or whether the cross-talk is an artifact from system calibration or a matrix calibration. To check for induction-related effects, the circuit connected to the unused coils is opened. If the signal on the other axes disappears when the other coils are open and re-appears when the other coils are closed (leads shorted), then induction is the source of the cross-talk.

In some embodiments, one member of the pair of bias coils 514 for the z-direction (hereinafter "Z-coil") is placed in contact with a heat sink. In some embodiments, additional material having high thermal and electrical conductivity is used (e.g., H20E-HC epoxy silver high conductivity, which may provide thermal conductivity values when properly cured at a characteristic temperature). For example, drops of H20E-HC epoxy are placed to hold the Z-coil onto the heat sink. Silicone rubber strips may be placed to provide support for Z-coils during curing to ensure Z-coil 514 positioning. Z-coil 514 is placed over epoxy drops and silicon strips making sure sufficient space exists between silicone strips and epoxy drops.

In some embodiments, RF PCB 502 is placed onto the heat sink. For example, a thin layer of H20E-HC epoxy is applied to the heat sink pedestal for the RF PCB. In some embodiments, some region (e.g., about 0.5 mm, about 1 mm, about 2 mm) along the edges of the heat sink pedestal is left uncoated. A first fixturing part is placed over the RF PCB 502 onto the center round portion of the heat sink pedestal.

In some embodiments, a fixturing plunger with a curved washer spring is placed into the center opening. In some embodiments, a pin is inserted into a slot to ensure correct orientation. A second fixturing part is placed over the first fixturing part. Fasteners (e.g., screws) are tightened to minimize any gaps left between the sensor heatsink and the first fixturing part, and also to minimize gaps left between the first fixturing part and the second fixturing parts. In some embodiments, the fixturing plunger includes a conical feature that is configured to press on the RF PCB 502 to center the RF PCB 502 the heat sink when the viscosity of the epoxy drops upon curing (e.g., after heating). In some embodiments, silicone strips keep Z-coil 514 up against the first fixturing part and the second fixturing parts to ensure the correct position of Z-coil 514 when epoxy is cured. In some embodiments, the sensor head unit 500 is assembled using a conical feature of a fixturing plunger to keep the RF PCB 502 centered. The fixturing plunger includes a center bore that keeps the NV diamond 506 centered to the RF PCB 502 (e.g., the center bore diameter matches a length of a diagonal of the NV diamond 506).

In some embodiments, the attachment of an RF cable is threaded through a cable clamp. An epoxy (e.g., H20E-HC epoxy) is applied on the sensor heatsink cable ledge and the RF cable is placed on and clamped over it. A fastener of the cable clamp (e.g., clamp screw) is tightened to ensure proper alignment of the cable clamp and the RF cable.

In some embodiments, the NV diamond 506 is placed on a fixturing tweezer. A thin layer of epoxy (e.g., H20E-HC epoxy) is applied on the NVD diamond 506 to minimize any build-up of epoxy near the edges of the NV diamond 506. The fixturing tweezer is inserted and pressed into the center of the first fixturing part and the second fixturing part, orienting a cross-bar of the fixturing tweezer to the slot in the top of the assembly.

In some embodiments, the assembly is placed on a hot plate and a weight is placed to keep the NV diamond 506 is pressed against the RF PCB 502 inside the assembly fixture. In some embodiments, after confirming that the RF cable is appropriately located and emerges from the cable clamp, the assembly is cured, and during the curing process, the RF cable center conductor is soldered to the RF PCB trace.

In some embodiments, a curved washer spring and the weight keep components compressed against one another to facilitate obtaining thinnest epoxy layers between different components. In some embodiments, spaces are provided around epoxying lines to make sure epoxy does not glue the fixturing parts to the sensor assembly.

In some embodiments, bias coils (e.g., bias coils 512, 514) are optimized to minimize gradients within the NV diamond 506 and minimize cross-coupling to neighboring(several centimeters away) sensor heads units. In some embodiments, RF PCB 502 and microwave coil are optimized for impedance matching and minimizing cross-talk between channels.

FIGS. 10A-10AX show various designs of the RF PCB element of the sensor head unit, in accordance with some embodiments.

FIG. 10A shows a microwave resonator (hereinafter alternatively called microwave coil, and RF PCB) designed in the form of a Bayat split ring resonator having a hole diameter of 2.4 mm, and the associated magnetic flux density over a frequency range of 2.7 to 3.4 GHz for such a Bayat split ring resonator.

FIG. 10B shows a microwave resonator designed in the form of a non-resonant loop, with an opening of a linear dimension of 1 mm. One resonance frequency of the structure is 2.87 GHz.

FIG. 10C shows a microwave resonator designed in the form of Sasaki resonator with an opening of a linear dimension of 1 mm. FIG. 10D shows the associated magnetic flux density and resonances over a frequency range of 2.5 to 3.2 GHz for such a Sasaki resonator.

FIG. 10E shows a microwave resonator designed in the form of loop-hole resonator having an opening of a linear dimension of 4 mm, and the associated magnetic flux density and resonances over a frequency range of 2.5 to 4 GHz inside the opening for such a loop-hole resonator.

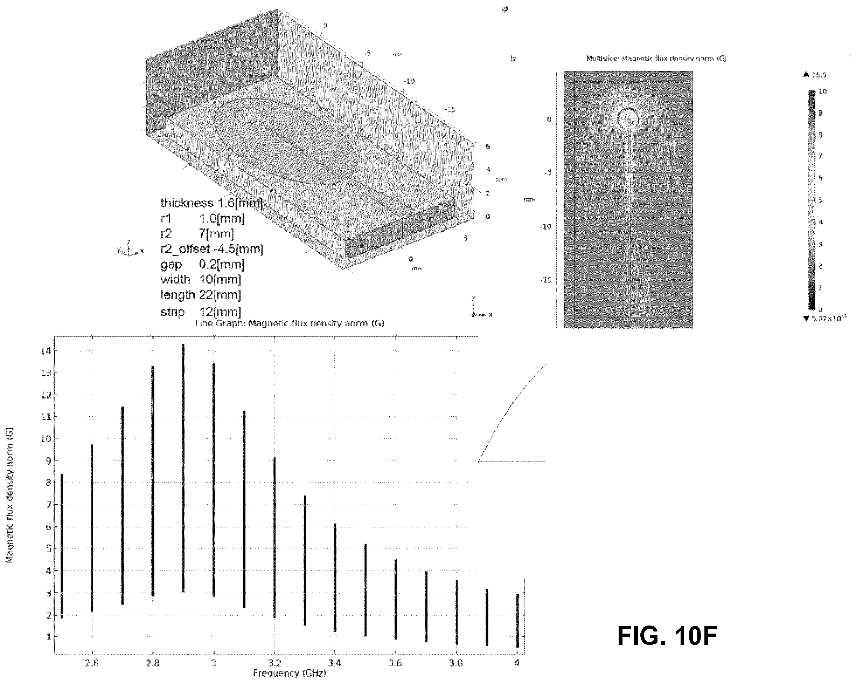

FIG. 10F shows a microwave resonator designed in the form of loop-hole resonator having an opening of a linear dimension of 2 mm, and the associated magnetic flux density and resonances over a frequency range of 2.5 to 4 GHz inside the opening for such a loop-hole resonator.

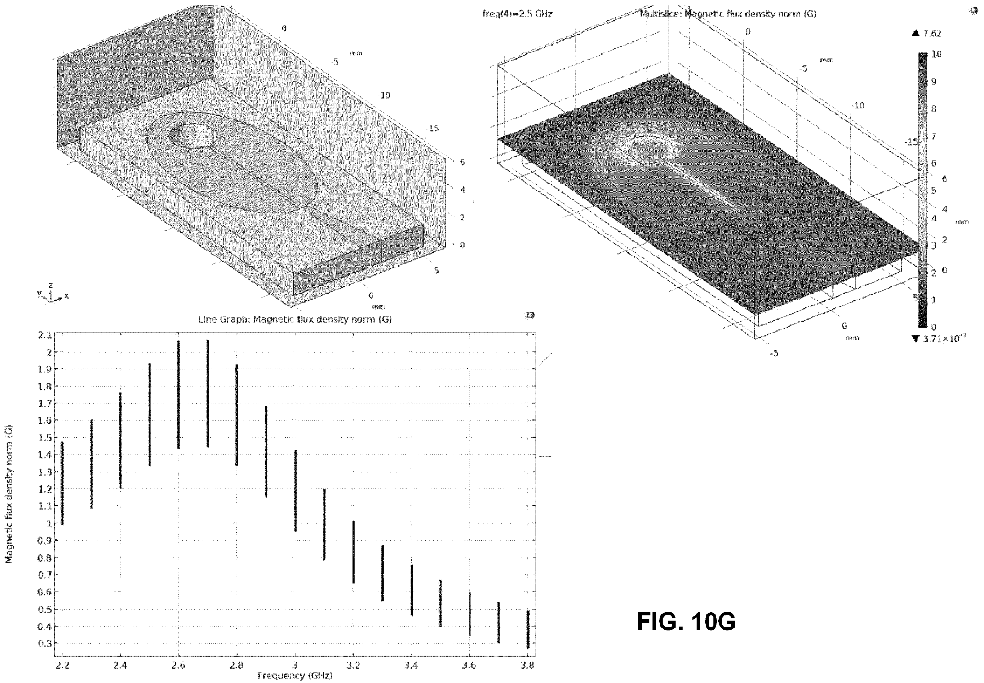

FIG. 10G shows a microwave resonator designed in the form of loop-hole resonator having an opening of a linear dimension of 3 mm, and the associated magnetic flux density and resonances over a frequency range of 2.2 to 3.8 GHz inside the opening for such a loop-hole resonator.

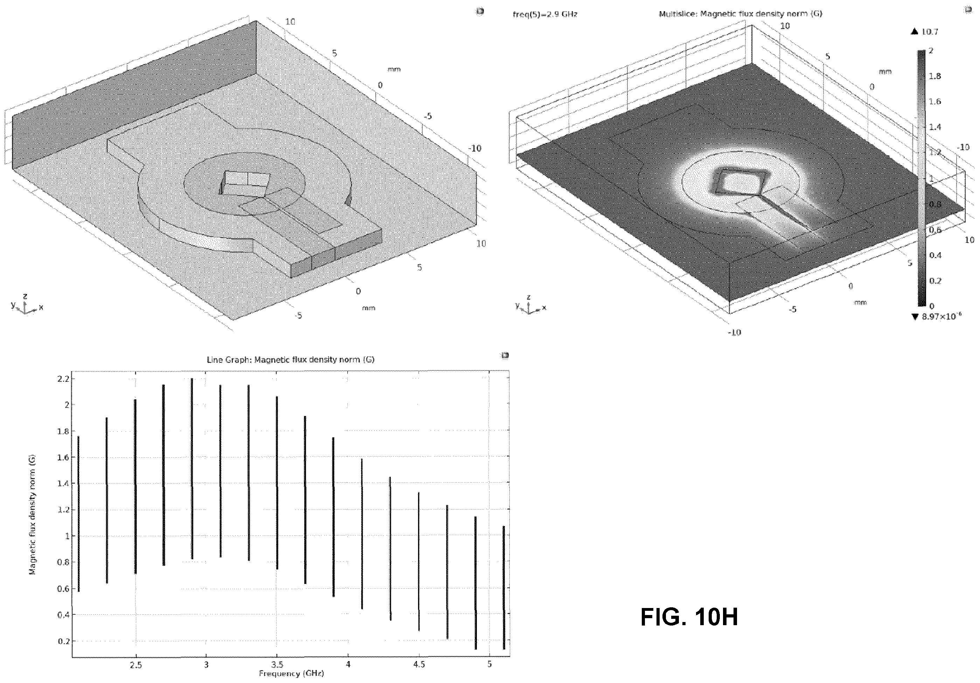

FIG. 10H shows a microwave resonator designed in the form of loop-hole resonator having a square opening for NV diamond 506 having a surface dimension of 3 mm $\times$ 3 mm, and the associated magnetic flux density and resonances over a frequency range of 2.2 to 5.1 GHz inside the opening for such a loop-hole resonator.

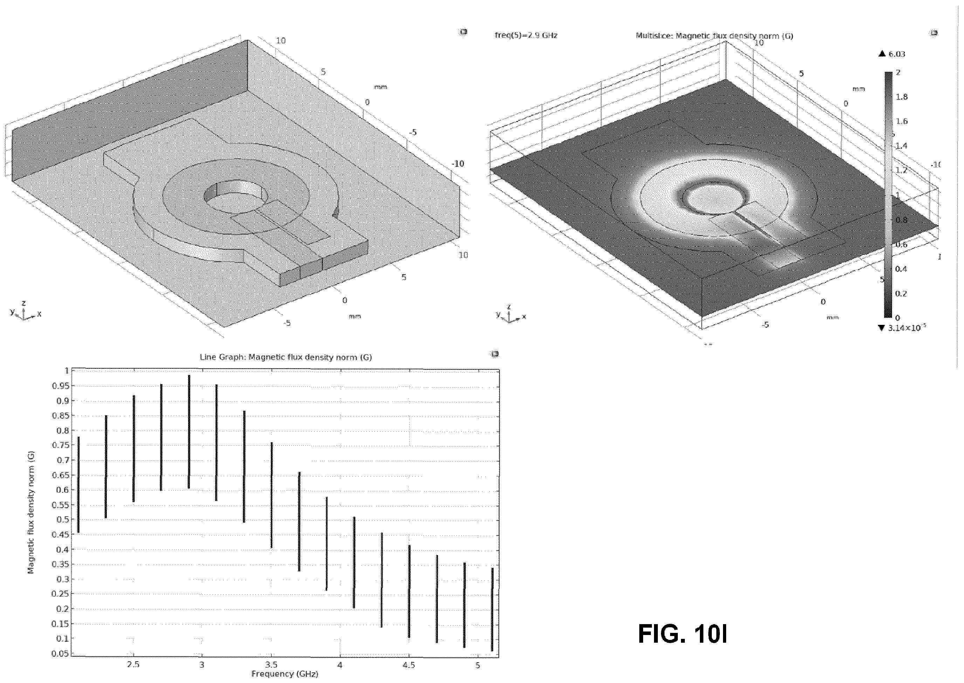

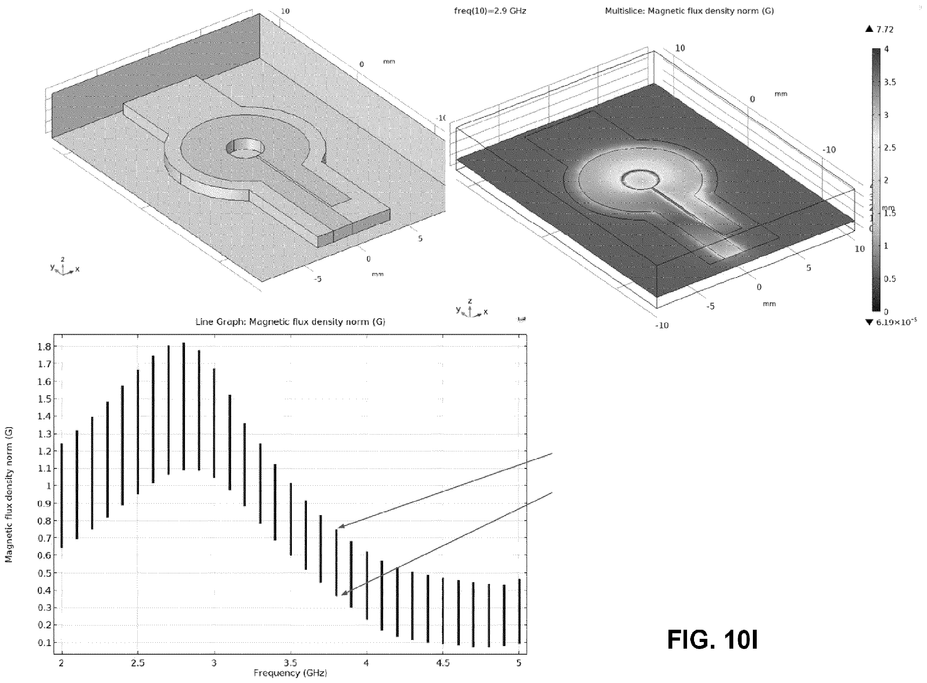

FIG. 10I shows a microwave resonator designed in the form of loop-hole resonator having a circular opening for NV diamond 506 having a surface dimension of 3 mm $\times$ 3 mm, and the associated magnetic flux density and resonances over a frequency range of 2.2 to 5.1 GHz inside the opening for such a loop-hole resonator.

FIG. 10J shows a microwave resonator designed in the form of loop-hole resonator having a circular opening of 3 mm diameter for NV diamond 506 having a surface dimension of 2 mm $\times$ 2 mm, and the associated magnetic flux density and resonances over a frequency range of 2.2 to 5.1 GHz inside the opening for such a loop-hole resonator.

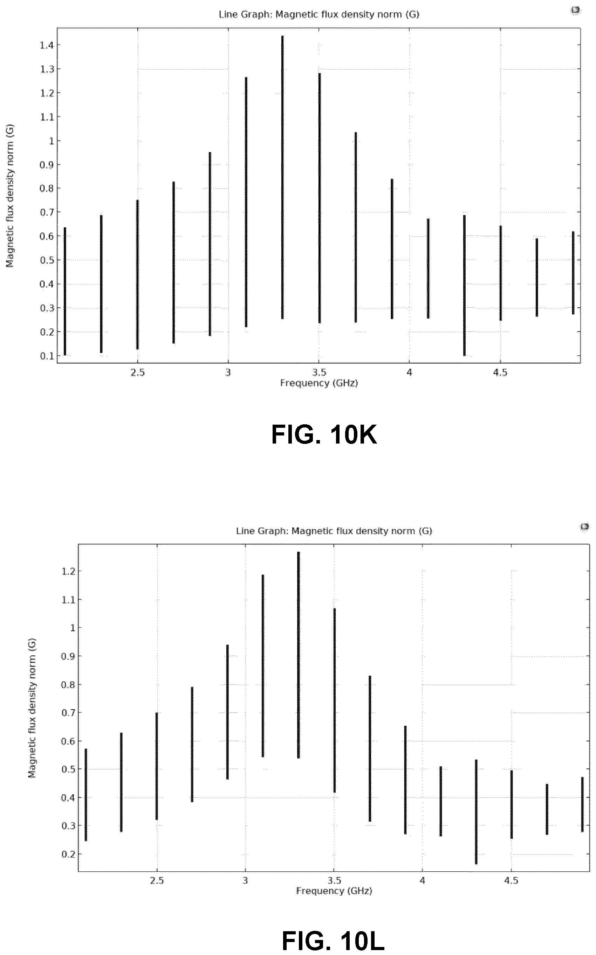

FIG. 10K shows the magnetic flux density over a frequency range of 2.2 to 5.0 GHz for a system having a copper heatsink and a CPC that is made of coated glass.

FIG. 10L shows the magnetic flux density over a frequency range of 2.2 to 5.0 GHz for a system having a AlN heatsink, a CPC that is made of coated glass, and a gap 520 of 0.2 mm.

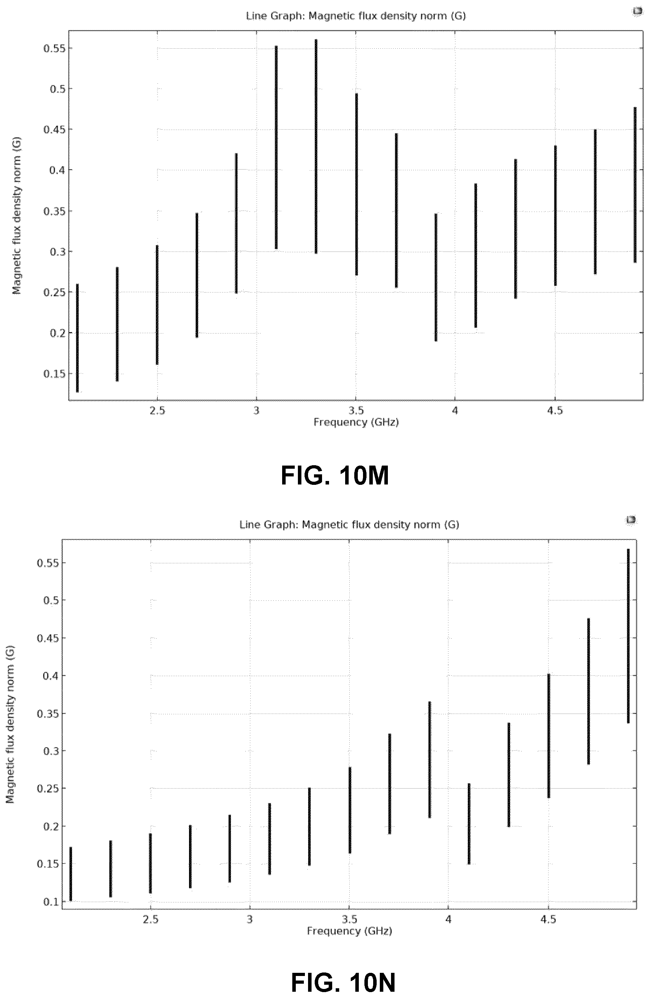

FIG. 10M shows the magnetic flux density over a frequency range of 2.2 to 5.0 GHz for a system having a AlN heatsink, a CPC that is made of coated glass, no gap.

FIG. 10N shows the magnetic flux density over a frequency range of 2.2 to 5.0 GHz for a system having a AlN heatsink, a CPC that is made of coated aluminum, no gap.

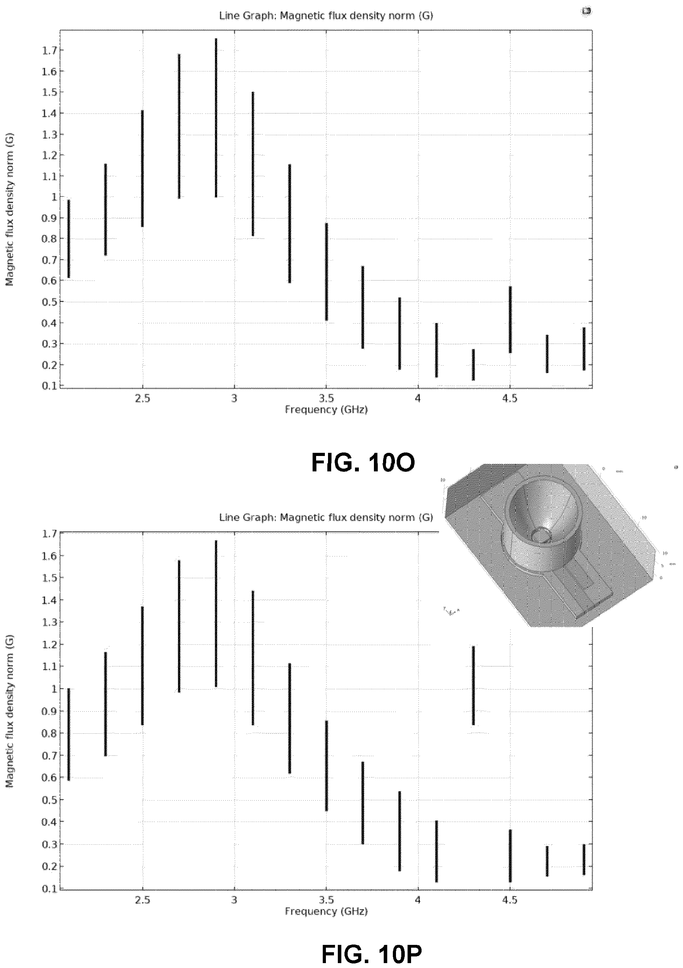

FIG. 10O shows the magnetic flux density over a frequency range of 2.2 to 5.0 GHz for a system having a AlN heatsink, a CPC that is made of partially coated aluminum, and a gap 520 of 0.2 mm.

FIG. 10P shows the magnetic flux density over a frequency range of 2.2 to 5.0 GHz for a system having a AlN heatsink, a CPC that is made of coated aluminum, and a gap 520 of 0.2 mm.

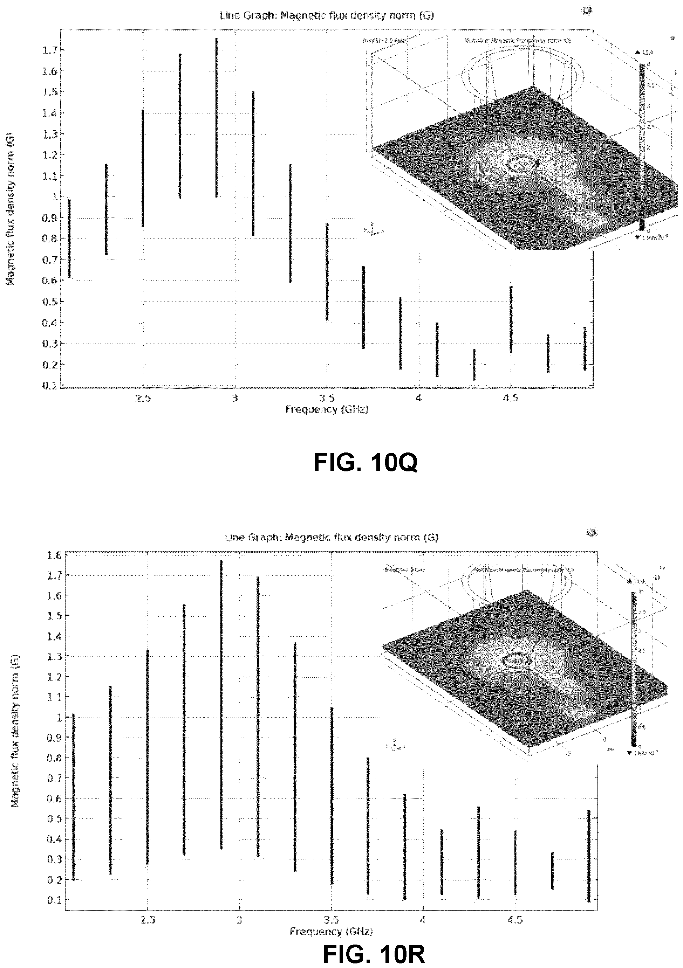

FIG. 10Q shows the magnetic flux density over a frequency range of 2.2 to 5.0 GHz for a system having a AlN heatsink, a CPC that is made of coated aluminum, and a gap 520 of 0.8 mm.

FIG. 10R shows the magnetic flux density over a frequency range of 2.2 to 5.0 GHz for a system having a copper heatsink, a CPC having a gap 520 of 0.8 mm.

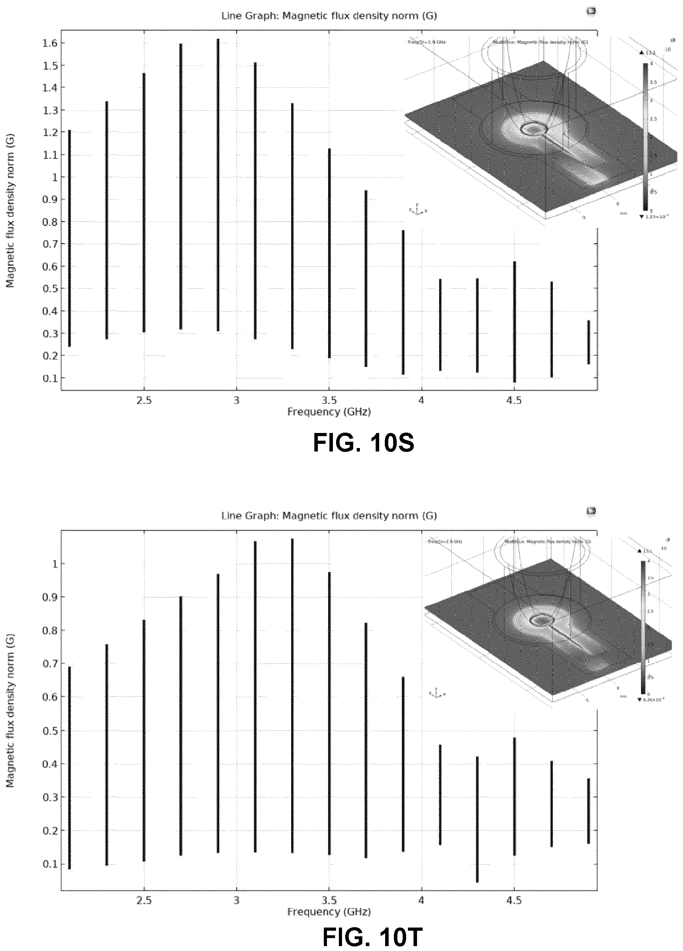

FIG. 10S shows the magnetic flux density over a frequency range of 2.2 to 5.0 GHz for a system having a copper heatsink, a CPC having a gap 520 of 0.8 mm, and a smaller circle for the PCB.

FIG. 10T shows the magnetic flux density over a frequency range of 2.2 to 5.0 GHz for a system having a copper heatsink, a CPC having no gap, and a smaller circle for the PCB.

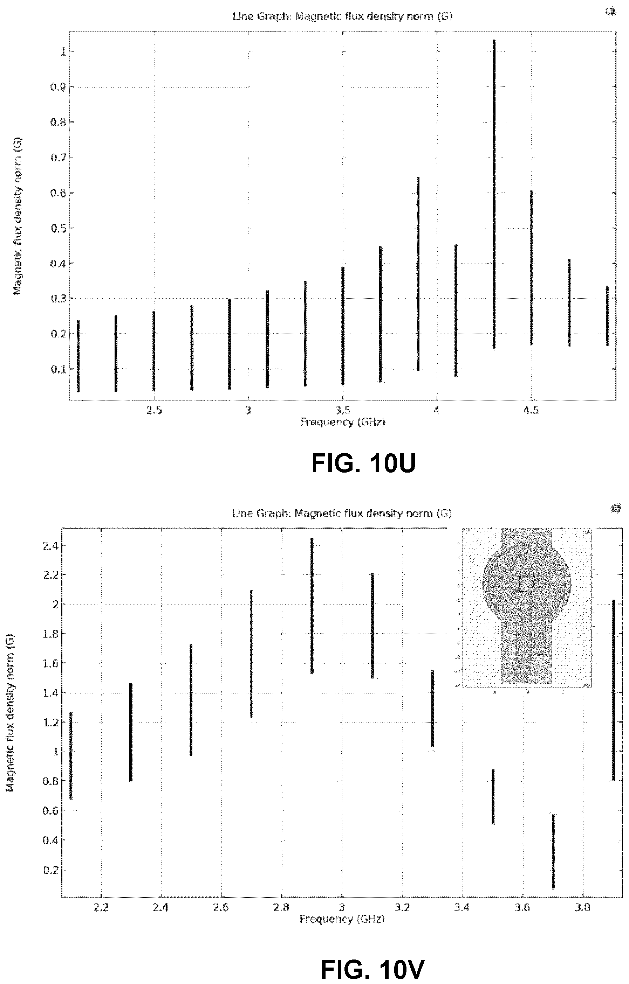

FIG. 10U shows the magnetic flux density over a frequency range of 2.2 to 5.0 GHz for a system having a copper heatsink, a full metal CPC having no gap, and a smaller circle for the PCB.

FIG. 10V shows the magnetic flux density over a frequency range of 2.1 to 3.9 GHz for a system having a AlN pedestal, a metal CPC with a slit, and a gap of 1 mm above a FR4 PCB.

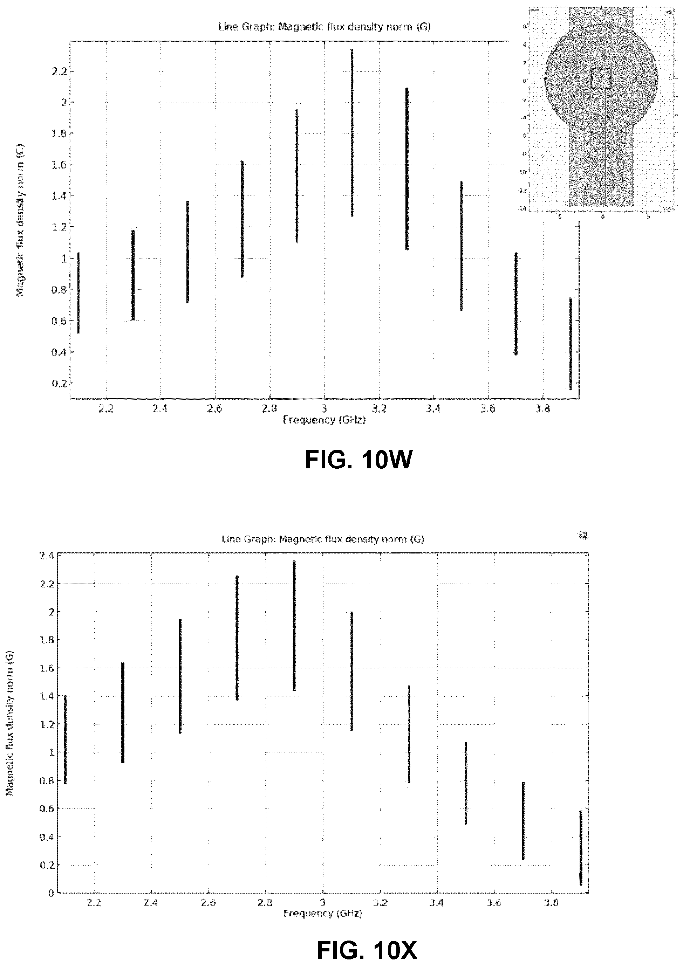

FIG. 10W shows the magnetic flux density over a frequency range of 2.1 to 3.9 GHz for a system having a AlN pedestal, a metal CPC with no slit, and a gap of 1 mm above a FR4 PCB.

FIG. 10X shows the magnetic flux density over a frequency range of 2.1 to 3.9 GHz for a system having a AlN pedestal, a coated CPC with a slit, and a gap of 1 mm above a FR4 PCB.

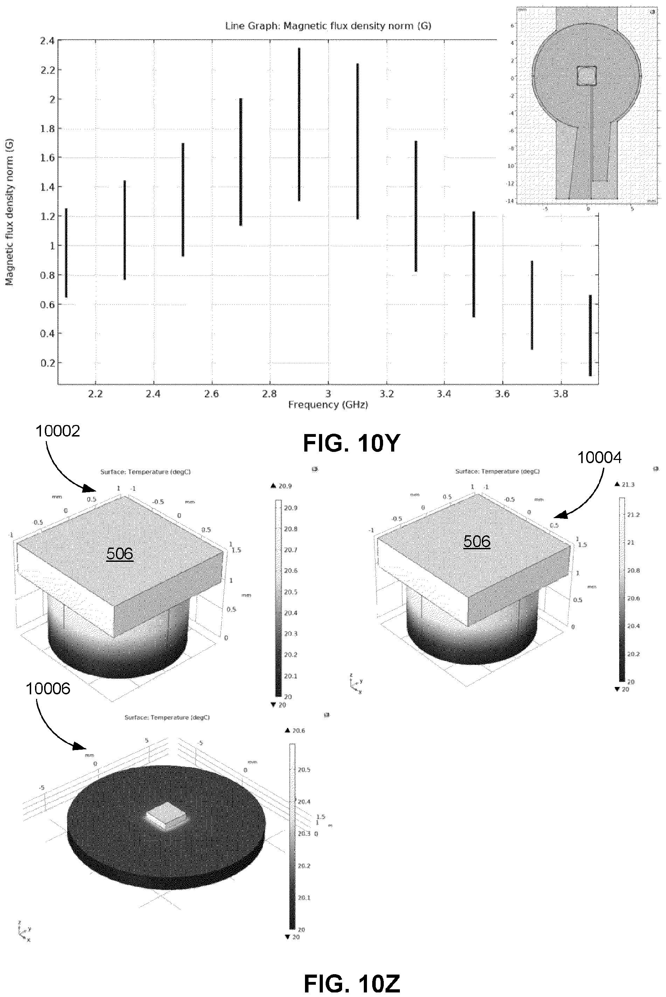

FIG. 10Y shows the magnetic flux density over a frequency range of 2.1 to 3.9 GHz for a system having a AlN pedestal, a coated CPC with no slit, and a gap of 1 mm above a FR4 PCB.

FIG. 10Z shows a temperature distribution 10002 in a copper pedestal, when 1W of heat is dissipated through a top surface of the NV diamond 506, and while a bottom surface of the AlN pedestal is kept at 20 °C, in accordance with some embodiments. The maximum temperature on the NV diamond 506 is 20.9 °C. FIG. 10Z also shows a temperature distribution 10004 in an AlN pedestal, when 1W of heat is dissipated through a top surface of the NV diamond 506, and while a bottom surface of the AlN pedestal is kept at 20 °C, in accordance with some embodiments. The maximum temperature on the NV diamond 506 is 21.3 °C. A temperature distribution 10006 in an AlN PCB composed of a 1 mm thick piece of AlN, with copper cladding on both sides of the AlN PCB, when 1W of heat is dissipated through a top surface of the NV diamond 506, and while a bottom surface of the AlN PCB is kept at 20 °C, in accordance with some embodiments. The maximum temperature on the NV diamond 506 is 20.6 °C.

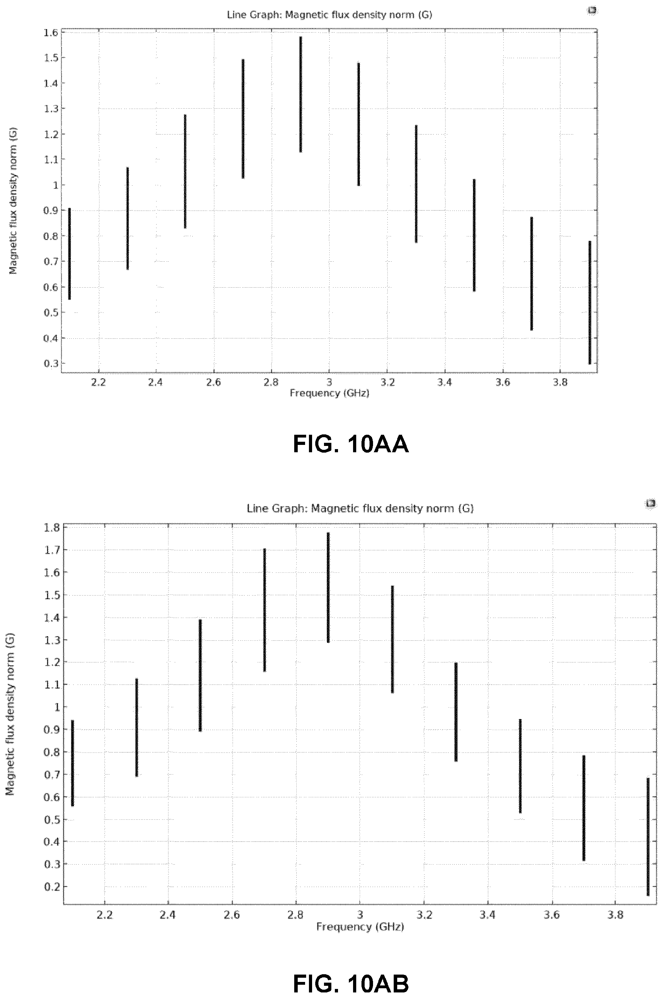

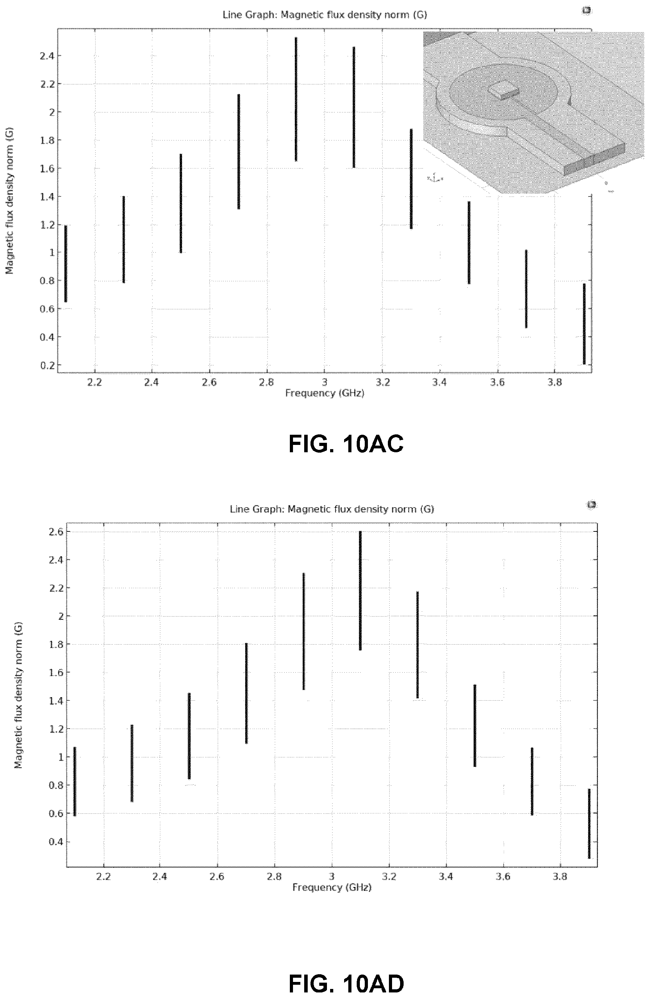

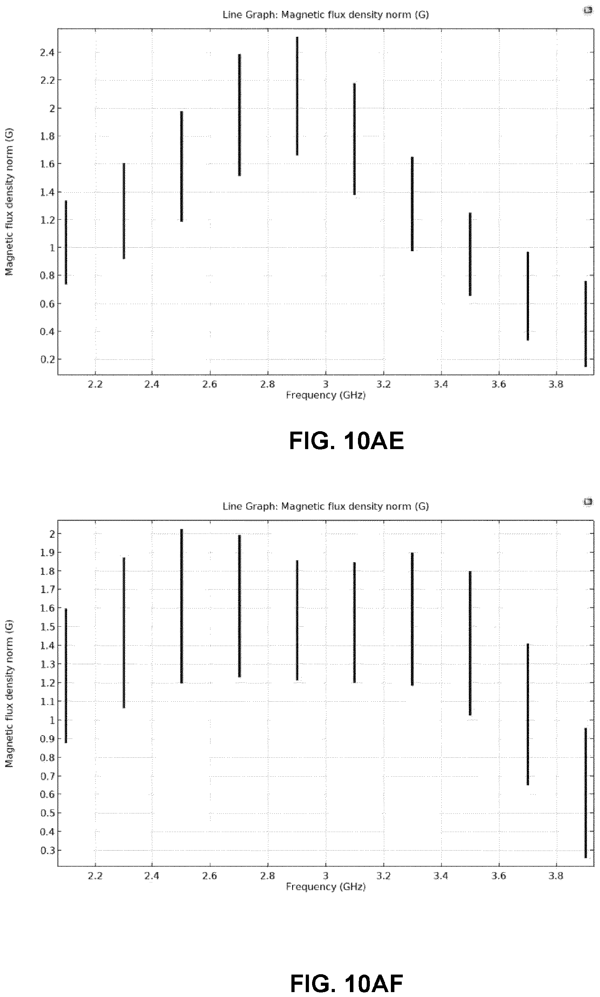

FIG. 10AA shows the magnetic flux density over a frequency range of 2.1 to 3.9 GHz for a system having a coated CPC and a gap 520 of 0.2 mm. FIG. 10AB shows the magnetic flux density over a frequency range of 2.1 to 3.9 GHz for a system having a metal CPC and a gap 520 of 0.5 mm. FIG. 10AC shows the magnetic flux density over a frequency range of 2.1 to 3.9 GHz for a system having a metal CPC and a gap 520 of 0.5 mm. FIG. 10AD shows the magnetic flux density over a frequency range of 2.1 to 3.9 GHz for the same system as that shown in FIG. 10AC, but with the relative dielectric constant, or relative static permitttivity $\varepsilon_r$ being 8, instead of 9 (FIG. 10AC). FIG. 10AE shows the magnetic flux density over a frequency range of 2.1 to 3.9 GHz for the same system as that shown in FIG. 10AE, but with the relative dielectric constant, or relative static permitttivity $\varepsilon_r$ being 10, instead of 9 (FIG. 10AD).

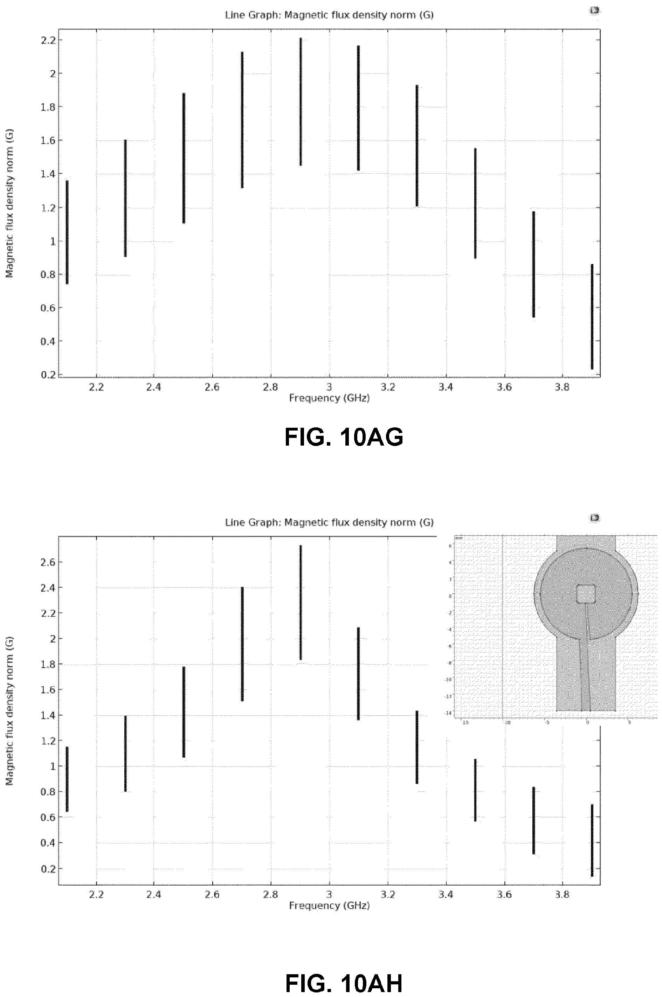

FIG. 10AF shows the magnetic flux density over a frequency range of 2.1 to 3.9 GHz for a system having a 2 mm wide input trace. FIG. 10AG shows the magnetic flux density over a frequency range of 2.1 to 3.9 GHz for a system having a 1.5 mm wide input trace. FIG. 10AH shows the magnetic flux density over a frequency range of 2.1 to 3.9 GHz for a system having a 1.0 mm wide input trace.

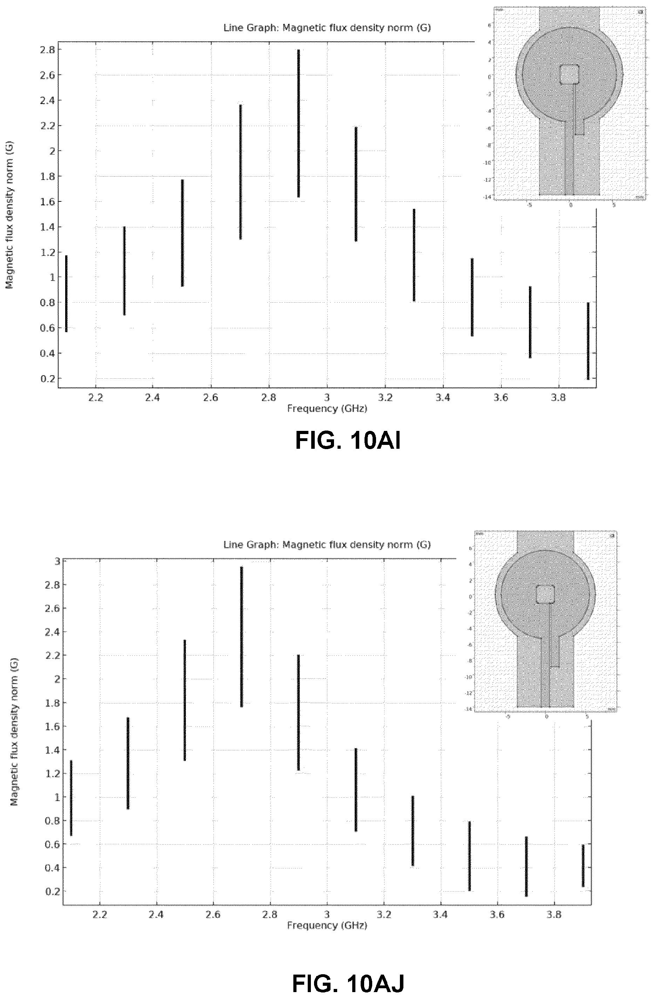

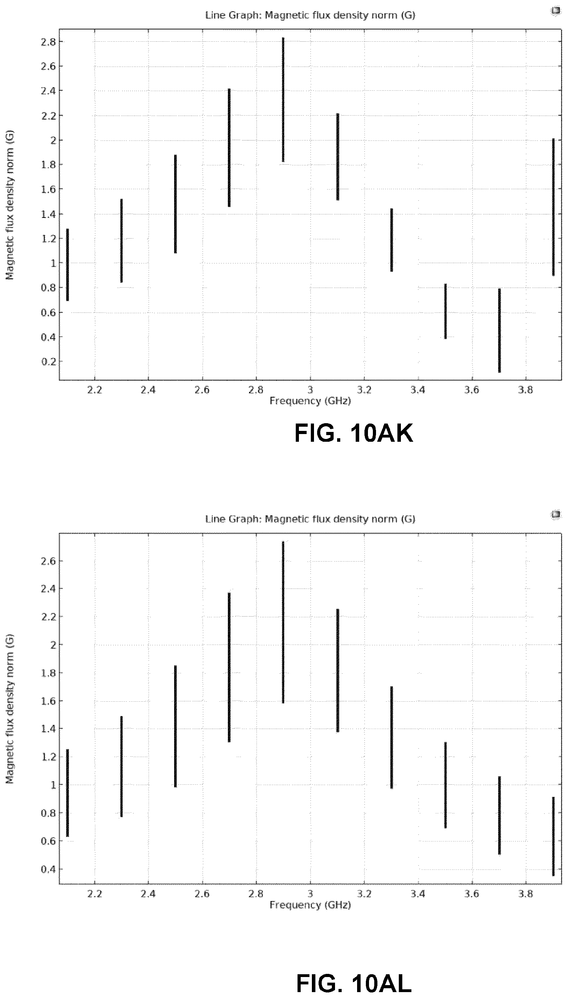

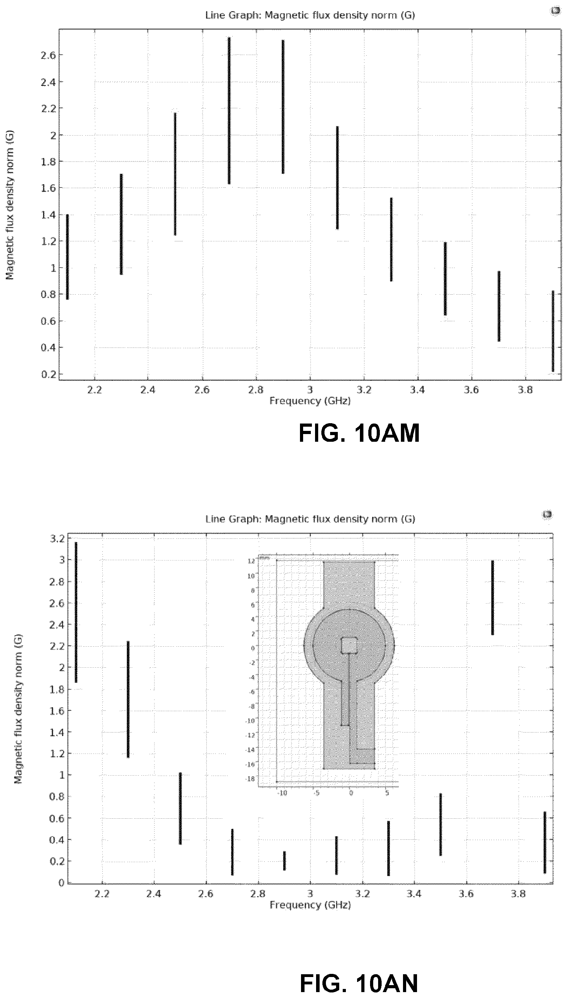

FIG. 10AI shows the magnetic flux density over a frequency range of 2.1 to 3.9 GHz for a system having a metal CPC and a gap 520 of 1 mm above the AlN PCB. FIG. 10AI shows the magnetic flux density over a frequency range of 2.1 to 3.9 GHz for a system having a metal CPC and a gap 520 of 1 mm above the AlN PCB. FIG. 10AJ shows the magnetic flux density over a frequency range of 2.1 to 3.9 GHz for a system having a metal CPC and a gap 520 of 1 mm above the AlN PCB. FIG. 10AK shows the magnetic flux density over a frequency range of 2.1 to 3.9 GHz for a system having a metal CPC with a slit, and a gap 520 of 1 mm above the AlN PCB. FIG. 10AL shows the magnetic flux density over a frequency range of 2.1 to 3.9 GHz for a system having a coated CPC with no slit, and a gap 520 of 1 mm above the AlN PCB. FIG. 10AM shows the magnetic flux density over a frequency range of 2.1 to 3.9 GHz for a system having a coated CPC with a slit, and a gap 520 of 1 mm above the AlN PCB.

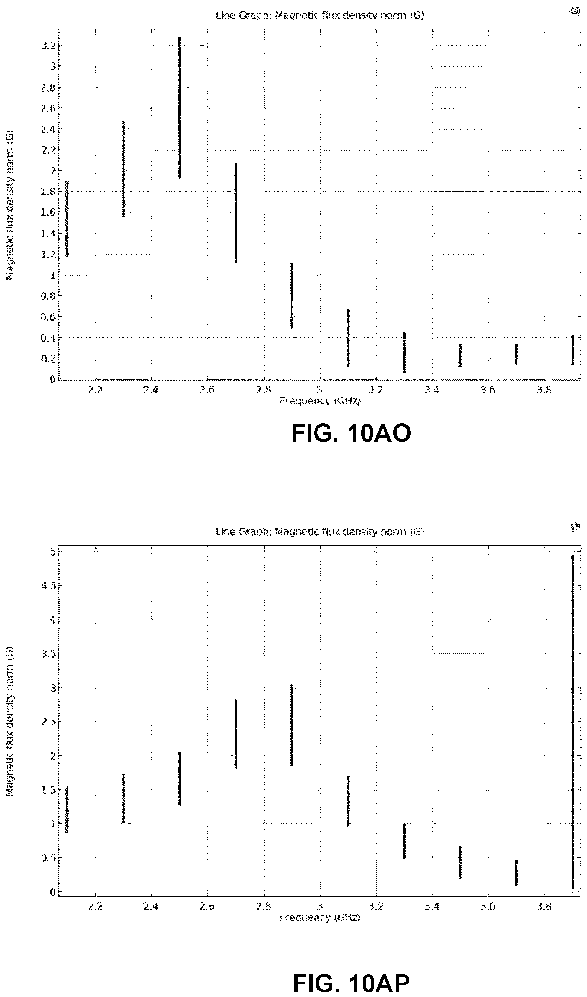

FIG. 10AN shows the magnetic flux density over a frequency range of 2.1 to 3.9 GHz for a system having a metal CPC with a slit, and a gap 520 of 1 mm above the AlN PCB, with a 3 mm cutback. FIG. 10AO shows the magnetic flux density over a frequency range of 2.1 to 3.9 GHz for a system having a metal CPC with a slit, and a gap 520 of 1 mm above the AlN PCB, with a 6 mm cutback. FIG. 10AP shows the magnetic flux density over a frequency range of 2.1 to 3.9 GHz for a system having a metal CPC with a slit, and a gap 520 of 1 mm above the AlN PCB, with a 9 mm cutback.

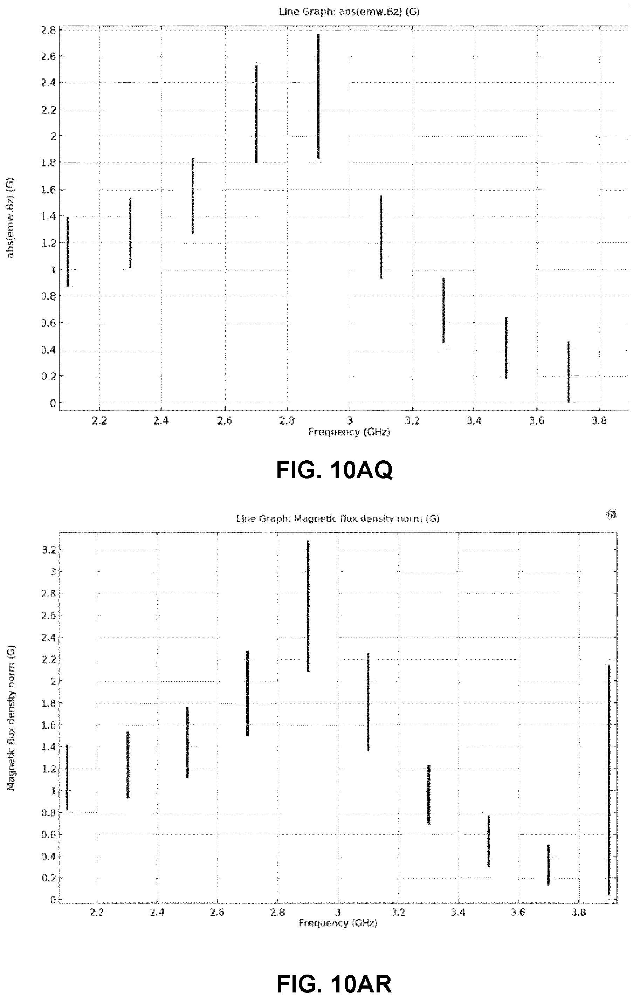

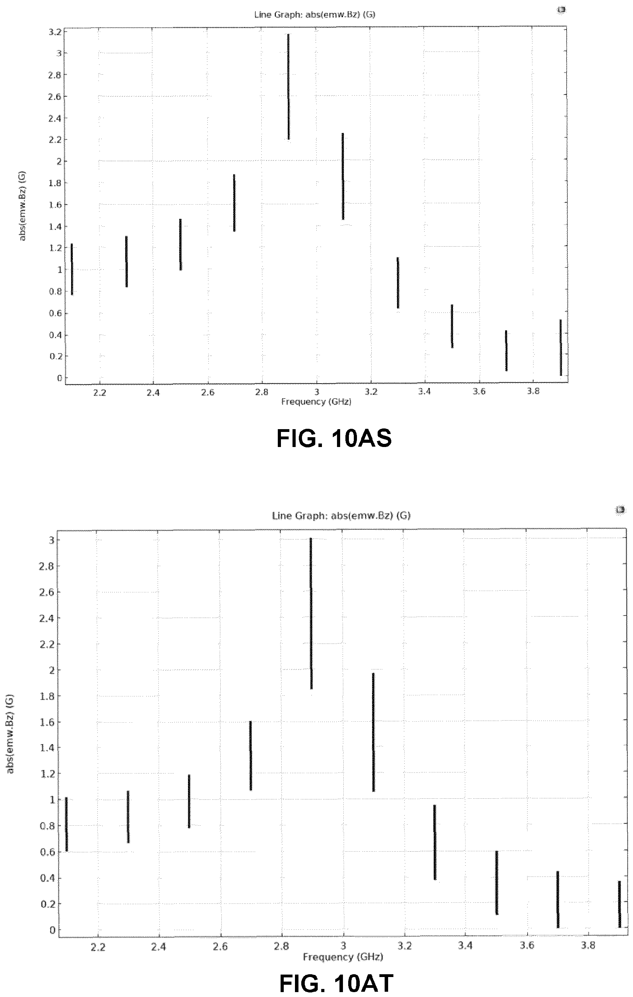

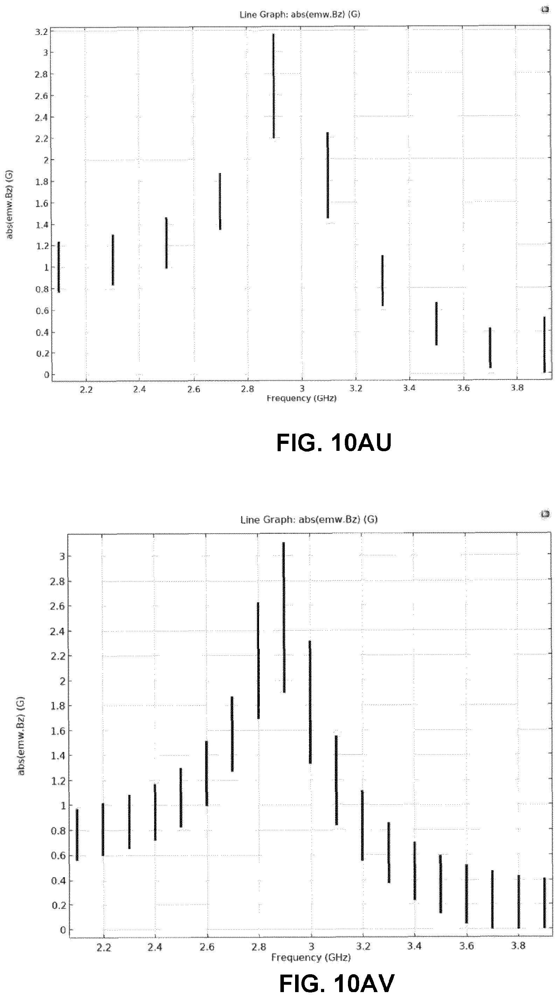

FIG. 10AQ shows the magnetic flux density over a frequency range of 2.1 to 3.9 GHz for a system having a metal CPC with a slit, and a gap 520 of 1 mm above the AlN PCB, with a 9 mm cutback. FIG. 10AR shows the magnetic flux density over a frequency range of 2.1 to 3.9 GHz for a system having a metal CPC with a slit, and a gap 520 of 1 mm above the AlN PCB, with a 10 mm cutback. FIG. 10AS shows the magnetic flux density over a frequency range of 2.1 to 3.9 GHz for a system having a metal CPC with a slit, and a gap 520 of 1 mm above the AlN PCB, with a 10 mm cutback. FIG. 10AT shows the magnetic flux density over a frequency range of 2.1 to 3.9 GHz for a system having a metal CPC with no slit, and a gap 520 of 1 mm above the AlN PCB, with a 8 mm cutback. FIG. 10AU shows the magnetic flux density over a frequency range of 2.1 to 3.9 GHz for a system having a metal CPC with no slit, and a gap 520 of 1 mm above the AlN PCB, with a 8 mm cutback, and a 1 mm larger diameter compared to that shown in FIG. 10AT.

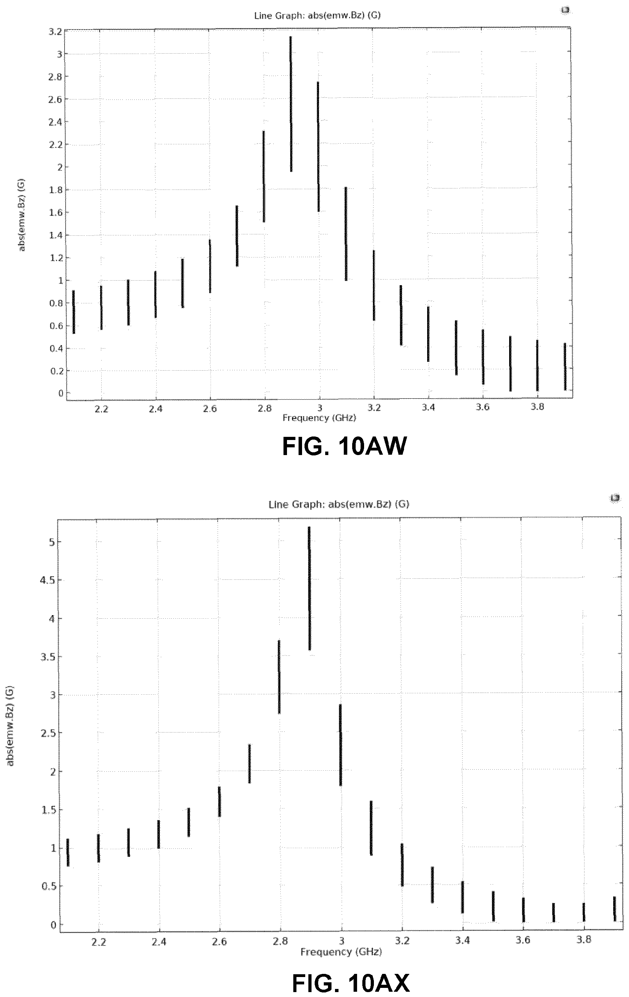

FIG. 10AV shows the magnetic flux density over a frequency range of 2.1 to 3.9 GHz for a system having a metal CPC with no slit, and a gap 520 of 1 mm above the AlN PCB, with a 8 mm cutback and a 0.2 mm gap. FIG. 10AW shows the magnetic flux density over a frequency range of 2.1 to 3.9 GHz for a system having a metal CPC with no slit, and a gap 520 of 1 mm above the AlN PCB, with a 8 mm cutback and a 0.25 mm gap. FIG. 10AX shows the magnetic flux density over a frequency range of 2.1 to 3.9 GHz for a system having a metal CPC with no slit, a gap 520 of 1 mm above the AlN PCB, and a 1.5 mm × 1.5 mm opening.

**Flowchart**

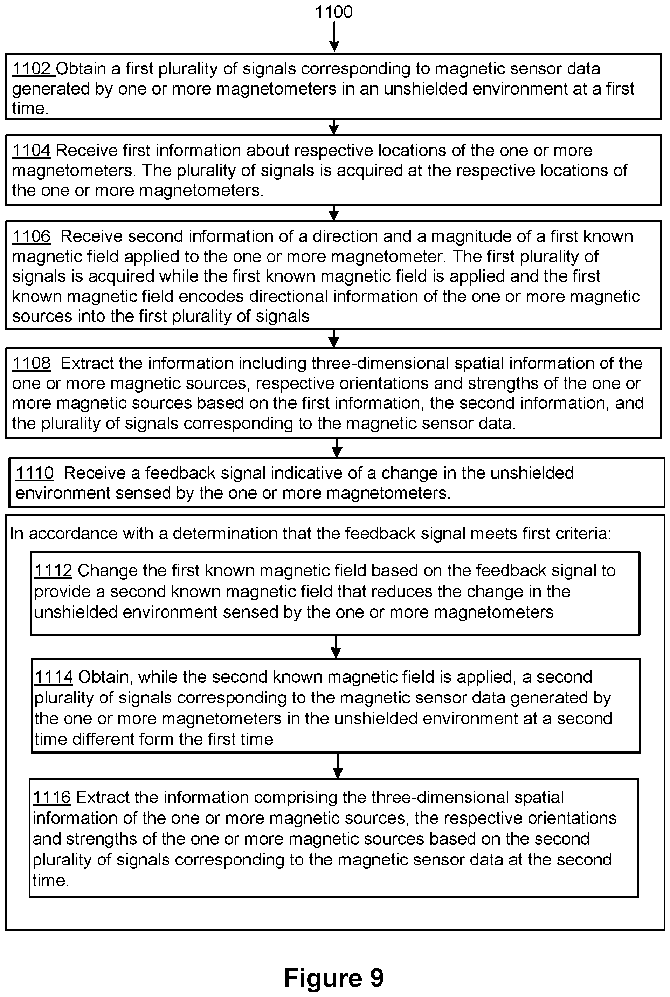

FIG. 9 provides a flowchart of a method 1100 for extracting information about one or more magnetic sources. The method 1100 is performed at a computing system (e.g., computer system 120) having one or more processors (e.g., CPU(s) 302 and memory (e.g., memory (306). The memory stores one or more programs configured for execution by the one or more processors. In some implementations, the operations shown in FIG. 1 - FIG. 8 and FIG. 10 correspond to instructions stored in the memory 206 or other non-transitory computer-readable storage medium. The computer-readable storage medium may include a magnetic or optical disk storage device, solid state storage devices such as Flash memory, or other non-volatile memory device or devices. In some implementations, the instructions stored on the computer-readable storage medium include one or more of: source code, assembly language code, object code, or other instruction format that is interpreted by one or more processors. Some operations in the method 700 may be combined and/or the order of some operations may be changed.

The computer obtains (1102) a first plurality of signals corresponding to magnetic sensor data generated by one or more magnetometers in an unshielded environment at a first time. The computer receives (1104) first information about respective locations of the one or more magnetometers. The plurality of signals is acquired at the respective locations of the one or more magnetometers. The computer receives (1106) second information of a direction and a magnitude of a first known magnetic field applied to the one or more magnetometer. The first plurality of signals is acquired while the first known magnetic field is applied and the first known magnetic field encodes directional information of the one or more magnetic sources into the first plurality of signals. The computer extracts (1108) the information including three-dimensional spatial information of the one or more magnetic sources, respective orientations and strengths of the one or more magnetic sources based on the first information, the second information, and the plurality of signals corresponding to the magnetic sensor data. The system receives (1110) a feedback signal indicative of a change in the unshielded environment sensed by the one or more magnetometers. In accordance with a determination that the feedback signal meets first criteria: the system changes (1112) the first known magnetic field based on the feedback signal to provide a second known magnetic field that reduces the change in the unshielded environment sensed by the one or more magnetometers, the system obtains (1114), while the second known magnetic field is applied, a second plurality of signals corresponding to the magnetic sensor data generated by the one or more magnetometers in the unshielded environment at a second time different form the first time, and the system extracts (1116) the information including the three-dimensional spatial information of the one or more magnetic sources, the respective orientations and strengths of the one or more magnetic sources based on the second plurality of signals corresponding to the magnetic sensor data at the second time.

The methods disclosed herein comprise one or more steps or actions for achieving the described method. The method steps and/or actions may be interchanged with one another without departing from the scope of the claims. In other words, unless a specific order of steps or actions is required for proper operation of the method that is being described, the order and/or use of specific steps and/or actions may be modified without departing from the scope of the claims.

As used herein, the term "plurality" denotes two or more. For example, a plurality of components indicates two or more components. The term "determining" encompasses a wide variety of actions and, therefore, "determining" can include calculating, computing, processing, deriving, investigating, looking up (e.g., looking up in a table, a database or another data structure), ascertaining and the like. Also, "determining" can include receiving (e.g., receiving information), accessing (e.g., accessing data in a memory) and the like. Also, "determining" can include resolving, selecting, choosing, establishing and the like.

The phrase "based on" does not mean "based only on," unless expressly specified otherwise. In other words, the phrase "based on" describes both "based only on" and "based at least on."

As used herein, the term "exemplary" means "serving as an example, instance, or illustration," and does not necessarily indicate any preference or superiority of the example over any other configurations or implementations.

As used herein, the term "and/or" encompasses any combination of listed elements. For example, "A, B, and/or C" includes the following sets of elements: A only, B only, C only, A and B without C, A and C without B, B and C without A, and a combination of all three elements, A, B, and C.

The terminology used in the description herein is for the purpose of describing particular implementations only and is not intended to be limiting of the claims. As used in the description the appended claims, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, steps, operations, elements, and/or components, but do not preclude the presence or addition of one or more other features, steps, operations, elements, components, and/or groups thereof.

The foregoing description, for purpose of explanation, has been described with reference to specific implementations. However, the illustrative discussions above are not intended to be exhaustive or to limit the claims to the precise forms disclosed. Many modifications and variations are possible in view of the above teachings. The implementations were chosen and described in order to best explain the principles of the claimed inventions and its practical applications, to thereby enable others skilled in the art to best utilize the claimed inventions and various implementations with various modifications as are suited to the particular use contemplated.

**Claims**

1. A method for extracting information about one or more magnetic sources, comprising:
   at a computer system having one or more processors and memory:

      obtaining a first plurality of signals corresponding to magnetic sensor data generated by one or more magnetometers in an unshielded environment at a first time;

receiving first information about respective locations of the one or more magnetometers, wherein the plurality of signals is acquired at the respective locations of the one or more magnetometers;

receiving second information of a direction and a magnitude of a first known magnetic field applied to the one or more magnetometer, wherein the first plurality of signals is acquired while the first known magnetic field is applied and wherein the first known magnetic field encodes directional information of the one or more magnetic sources into the first plurality of signals;

extracting the information comprising three-dimensional spatial information of the one or more magnetic sources, respective orientations and strengths of the one or more magnetic sources based on the first information, the second information, and the plurality of signals corresponding to the magnetic sensor data;

receiving a feedback signal indicative of a change in the unshielded environment sensed by the one or more magnetometers;

in accordance with a determination that the feedback signal meets first criteria:

> changing the first known magnetic field based on the feedback signal to provide a second known magnetic field that reduces the change in the unshielded environment sensed by the one or more magnetometers; obtaining, while the second known magnetic field is applied, a second plurality of signals corresponding to the magnetic sensor data generated by the one or more magnetometers in the unshielded environment at a second time different form the first time; and extracting the information comprising the three-dimensional spatial information of the one or more magnetic sources, the respective orientations and strengths of the one or more magnetic sources based on the second plurality of signals corresponding to the magnetic sensor data at the second time.

2. The method of claim 1, further comprising, removing noise from the plurality of signals based on the first information, the second information, and the plurality of signals corresponding to the magnetic sensor data.

3. The method of any of the preceding claims, wherein the one or more magnetometers each comprises an electron spin defect body, wherein the electron spin defect body comprises a plurality of lattice point defects.

4. The method of claim 3, wherein the electron spin defect body comprises a nitrogen-vacancy diamond portion; and the first known magnetic field changes a characteristic of an output from the nitrogen-vacancy diamond portion.

5. The method of claim 4, wherein output from the nitrogen-vacancy diamond portion comprises red fluorescence emitted by the nitrogen-vacancy diamond portion that is collected via a parabolic mirror positioned at an offset from the nitrogen-vacancy diamond portion.

6. The method of claim 4, further comprising applying the first known magnetic field to generate an output from the nitrogen-vacancy diamond portion that comprises pairs of non-degenerate signals for simultaneous vector measurements (SVM).

7. The method of claim 6, wherein the pairs of non-degenerate signals correspond to eight distinct nitrogen-vacancy (NV) resonances that are individually addressable with microwave fields.

8. The method of claim 7, wherein the NV resonances are separated from one another to minimize crosstalk.

9. The method of claim 7, wherein intermodulation products of applied microwave drive frequencies do not overlap with at least one of the NV resonances.

10. The method of claim 4, further comprising projecting a non-zero component of the first known magnetic field onto four symmetry axes of the nitrogen-vacancy diamond portion.

11. The method of claim 10, further comprising tuning an optical pump polarization to address four symmetry axes of the nitrogen-vacancy diamond portion while the first known magnetic field is applied.

12. The method of any of the preceding claims, wherein obtaining the plurality of signals corresponding to the magnetic sensor data generated by one or more magnetometers comprises obtaining the plurality of signals corresponding to the magnetic sensor data generated by an array of magnetometers, the method further comprising: extracting the information of the magnetic source by pairing the plurality of signals corresponding to the magnetic sensor data generated by the array of magnetometers with the first information of the respective locations of the array of magnetometers.

13. The method of any of the preceding claims, wherein the first plurality of signals includes information about respective detected frequency shifts, and the method further includes determining a transformation matrix based on the first known magnetic field, and wherein the transformation matrix is configured to transform the respective detected frequency shifts into the information about the one or more magnetic sources that includes magnetic field directions of the one or more magnetic sources.

14. A computer system for determining magnetic fields, comprising:

> one or more processors; and
> memory; and
> one or more programs stored in the memory for execution by the one or more processors, the one or more programs comprising instructions for performing the method of any of the preceding claims.

15. A non-transitory computer readable storage medium storing computer-executable instructions, when executed by one or more processors of a computer system, cause the one or more processors to perform the method of any of claims 1-13.

Operating Environment 100

Site A

120-1

122-1 200-1

140

Site N

Site B

122-2 200-2

Communication Network 110

Computer system 120

Data receiving module 124

Data processing module 126

Database 128

Machine Learning Database 130

FIG. 1

Magnetic Field Sensing Device 200

CPU(s) 202

Communication Interface(s) 204

Memory 206

208

Radios 220

Operating Logic 222

Communications Module 224

Application 230

Acquisition module 232

Processing module 234

⋮

Data 242

Magnetic field data 244

Device settings 246

User settings 248

⋮

Magnetometers 201

Input interface 210

Display 212

Button(s) 214

Keyboard/ Mouse 216

Audio Output Device(s) 218

Audio Input Device(s) 220

**FIG. 2**

EP 4 579 263 A2

Computer System 120

Memory 306

| Operating System 322 |
| --- |
| User Interface Module 323 |
| Data Receiving Module 124 |
| Data Processing Module 126 |
| Training Module 324 |

Database 128

| Magnetic field data 244 |
| --- |
| Site information 332 |
| Training data 334 |
| ⋮ |

Machine Learning Database 130

Neural Network Data 328

| Machine Learning Data 330 |
| --- |
| Correction Data 332 |
| |

⋮

CPU(s) 302

308

Input Device(s) 310

Output Device(s) 312

Network Interface 304

**FIG. 3**

400

m_s=1

m_s=-1

m_s=0

404

406

414

408

412

m_s=1

m_s=±1

m_s=-1

402

410

m_s=0

**FIG. 4A**

FIG. 4B

FIG. 4C

FIG. 4D

FIG. 5A

502

506

# FIG. 5B

508

518

516

504

510

512

512

502

FIG. 5C

FIG. 5D

FIG. 5E

1. Chip 2. + Bottom HR 3. + Sides HR

4. + Top AR 5. + Wedge - Down 6. + Wedge - Up

**FIG. 5F1**

EP 4 579 263 A2

## 1. Round CPC

**CPC - Air Inside**

**CPC - Air Outside**

1. 90deg Edge, (No Edge HR)
2. 90deg Edges (Edge HR)
3. 45deg Edges (No Edge HR)
4. 45deg Edges (Edge HR)

**FIG. 5F2**

FIG. 5G

FIG. 5H

FIG. 5I

FIG. 5I

**FIG. 6A**

freq(9)=2.9 GHz       Multislice: abs(emw.Bz) (G)

Line Graph: abs(emw.Bz) (G)

**FIG. 6B**

EP 4 579 263 A2

FIG. 7

EP 4 579 263 A2

FIG. 8

1100

1102 Obtain a first plurality of signals corresponding to magnetic sensor data generated by one or more magnetometers in an unshielded environment at a first time.

1104 Receive first information about respective locations of the one or more magnetometers. The plurality of signals is acquired at the respective locations of the one or more magnetometers.

1106 Receive second information of a direction and a magnitude of a first known magnetic field applied to the one or more magnetometer. The first plurality of signals is acquired while the first known magnetic field is applied and the first known magnetic field encodes directional information of the one or more magnetic sources into the first plurality of signals

1108 Extract the information including three-dimensional spatial information of the one or more magnetic sources, respective orientations and strengths of the one or more magnetic sources based on the first information, the second information, and the plurality of signals corresponding to the magnetic sensor data.

1110 Receive a feedback signal indicative of a change in the unshielded environment sensed by the one or more magnetometers.

In accordance with a determination that the feedback signal meets first criteria:

1112 Change the first known magnetic field based on the feedback signal to provide a second known magnetic field that reduces the change in the unshielded environment sensed by the one or more magnetometers

1114 Obtain, while the second known magnetic field is applied, a second plurality of signals corresponding to the magnetic sensor data generated by the one or more magnetometers in the unshielded environment at a second time different form the first time

1116 Extract the information comprising the three-dimensional spatial information of the one or more magnetic sources, the respective orientations and strengths of the one or more magnetic sources based on the second plurality of signals corresponding to the magnetic sensor data at the second time.

**Figure 9**

FIG. 10A

**FIG. 10B**

Hole diameter: 1 mm

**FIG. 10C**

Line Graph: Magnetic flux density norm (G)

Magnetic flux density norm (G)

Frequency (GHz)

Microwave power = 1 W

Hole diameter: 1 mm

**FIG. 10D**

43

freq(5)=2.9 GHz

Multislice: Magnetic flux density norm (G)

Line Graph: Magnetic flux density norm (G)

**FIG. 10E**

thickness 1.6[mm]
r1       1.0[mm]
r2       7[mm]
r2_offset -4.5[mm]
gap     0.2[mm]
width   10[mm]
length 22[mm]
strip    12[mm]

Multislice: Magnetic flux density norm (G)

Line Graph: Magnetic flux density norm (G)

**FIG. 10F**

EP 4 579 263 A2

**FIG. 10G**

freq(5)=2.9 GHz     Multislice: Magnetic flux density norm (G)

Line Graph: Magnetic flux density norm (G)

FIG. 10H

EP 4 579 263 A2

EP 4 579 263 A2

FIG. 10I

48

FIG. 10I

**FIG. 10K**

**FIG. 10L**

**FIG. 10M**

**FIG. 10N**

FIG. 10O

FIG. 10P

**FIG. 10Q**

**FIG. 10R**

FIG. 10S

FIG. 10T

FIG. 10U

FIG. 10V

FIG. 10W

FIG. 10X

**FIG. 10Y**

**FIG. 10Z**

## FIG. 10AA

## FIG. 10AB

EP 4 579 263 A2

**FIG. 10AC**

**FIG. 10AD**

**FIG. 10AE**

**FIG. 10AF**

**FIG. 10AG**

**FIG. 10AH**

**FIG. 10AI**

**FIG. 10AJ**

**FIG. 10AK**

**FIG. 10AL**

**FIG. 10AM**

**FIG. 10AN**

FIG. 10AO

FIG. 10AP

**FIG. 10AQ**

**FIG. 10AR**

**FIG. 10AS**

**FIG. 10AT**

**FIG. 10AU**

**FIG. 10AV**

FIG. 10AW

FIG. 10AX

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63604773
- US 96136424

- US 472209